(19) Europäisches Patentamt

European Patent Office

Office européen des brevets

(11) EP 0 655 685 B1

(12) **FASCICULE DE BREVET EUROPEEN**

(45) Date de publication et mention
de la délivrance du brevet:
**25.08.1999 Bulletin 1999/34**

(51) Int Cl.$^6$: **G06F 11/10**

(21) Numéro de dépôt: **94402685.5**

(22) Date de dépôt: **24.11.1994**

(54) **Dispositif de calcul des bits de parité associés à une somme de deux nombres**

Einrichtung zum Berechnen von Paritätsbits in Verbindung mit einer Summe zweier Zahlen

Parity bit calculation device associated with a sum of two numbers

(84) Etats contractants désignés:
**DE FR GB IT**

(30) Priorité: **30.11.1993 FR 9314287**

(43) Date de publication de la demande:
**31.05.1995 Bulletin 1995/22**

(73) Titulaire: **BULL S.A.**
**78430 Louveciennes (FR)**

(72) Inventeurs:
• **Thill, Michel**
**F-78430 Les Clayes Sous Bois (FR)**

• **Delamotte, Pascal**
**F-92500 Rueil Malmaison (FR)**

(74) Mandataire: **Denis, Hervé et al**
**Direction de la Propriété Intellectuelle BULL SA,**
**Poste courrier: LV59C18,**
**68 route de Versailles**
**78430 Louveciennes (FR)**

(56) Documents cités:
**EP-A- 0 329 545     EP-A- 0 339 296**

## Description

L'invention concerne le calcul des bits de parité associés au résultat d'une addition effectuée par un additionneur, notamment dans les processeurs des ordinateurs.

De façon générale, les bits de parité associés à des mots ou à des nombres binaires sont utilisés pour pouvoir détecter si ces mots ou ces nombres n'ont pas été entachés d'erreurs au cours de leur manipulation dans les circuits de traitement.

Le bit de parité associé à un mot est habituellement défini comme le résultat de la combinaison par des opérations de type "OU EXCLUSIF" de tous les bits constituant le mot. Le bit de parité prend donc la valeur "1" si le nombre de "1" contenus dans le mot est impair. Ainsi, lorsqu'un seul bit ou un nombre impair de bits du groupe sont erronés, le bit de parité prend la valeur complémentaire de la valeur qu'il devrait avoir. Les erreurs peuvent donc être détectées par simple comparaison entre la parité réelle calculée à partir des bits formant le mot et la valeur du bit de parité. Pour augmenter le taux de détection d'erreurs, il est habituel de scinder les mots en K groupes de m bits, chaque groupe étant associé à un bit de parité. Un mot peut donc être associé à plusieurs bits de parité. Par exemple, un mot de 32 bits peut être scindé en quatre groupes de huit bits, chaque groupe étant associé à un bit de parité. Cette méthode permet de détecter des erreurs multiples portant sur des groupes différents.

Lorsque des opérations portant sur un ou plusieurs mots sont effectuées, il convient que le résultat de cette opération soit aussi associé à un ou plusieurs bits de parité. C'est le cas en particulier pour les opérations d'addition.

Le ou les bits de parité associés au résultat d'une addition pourraient être calculés directement à partir du résultat. Toutefois, dans ce cas, les bits de parité du résultat ne pourraient être obtenus que bien après le résultat lui-même, ce qui retarde le moment où le résultat et ses bits de parité associés peuvent être utilisés dans la suite du traitement.

Dans une unité arithmétique et logique moderne, comprenant un additionneur de 32 ou même de 64 bits, le problème de la détection des erreurs devient toujours plus crucial. Une méthode pour détecter efficacement les erreurs consiste à prédire les bits de parité de la somme indépendamment de son calcul, puis à calculer les bits de parité directement à partir du résultat obtenu. La comparaison de ces bits permet le cas échéant de générer un signal d'erreur indiquant un mauvais fonctionnement de l'additionneur. Dans ce cas également, il est souhaitable de disposer des bits de parité prévus à partir des opérandes au plus tard au moment où le résultat de l'addition est disponible.

Le problème de la prédiction des bits de parité d'une somme est abordé dans de nombreux articles qui donnent des solutions dans des cas particuliers. Cet état de la technique est par exemple illustré par la publication IBM Technical Disclosure Bulletin, Volume 23, numéro 12, mai 1981, pages 5498 à 5502.

De même, le brevet US4224680 intitulé "Parity prediction circuit for adder/counter" propose une réalisation adaptée aux compteurs et aux additionneurs à propagation de retenue ("carry ripple adder" dans la terminologie anglaise). Le circuit proposé utilise une pluralité d'étages PP0 à PPn montés en cascade. Chaque étage fournit les bits de transmission $x_i$ et $y_i$ tels que:

$$x_i = (p_i \cdot x_{i-1})^\star,$$

$$y_i = y_{i-1 \overline{\oplus}} (g_i \cdot x_{i-1})^\star$$

où

$$p_i = a_i {}_\oplus b_i,$$

$$g_i = a_i \cdot b_i$$

$a_i$ et $b_i$ étant les bits des opérandes, $\oplus$ étant l'opération "OU EXCLUSIF", $\overline{\oplus}$ étant l'opération complémentaire du "OU EXCLUSIF", le symbole * indiquant l'opération de complémentation.

Le bit de parité de la somme est ensuite obtenu par un étage de sortie PPout effectuant une opération logique sur $x_n$, $y_n$, $C_{in}$, Pa, Pb, où $C_{in}$ est la retenue d'entrée et Pa et Pb les parités des opérandes. Cette solution n'est toutefois pas satisfaisante en combinaison avec des additionneurs rapides comme les additionneurs à anticipation de retenue ("carry look ahead" en anglais), car dans ce cas le bit de parité serait obtenu bien après le résultat de l'addition, ce qui retarderait la suite du traitement.

Le brevet EP329545 de la demanderesse, intitulé "Dispositif pour le calcul des bits de parité d'une somme de deux nombres", propose une réalisation adaptée même aux additionneurs rapides comme les additionneurs à anticipation de retenue. Les bits de parité de la somme sont obtenus dans cette réalisation par calcul de la parité sur le mot de retenue et non pas sur le mot de somme.

Les additionneurs à anticipation de retenue permettent d'obtenir tous les bits de retenue avant les bits de somme et donc ce brevet propose une solution selon laquelle, une fois le calcul des bits de retenue effectué, le temps ensuite nécessaire pour déduire les bits de parité associés est réduit au maximum. Le dispositif effectue un calcul en deux étapes:

- une première étape qui utilise comme variables d'entrée des variables qui dépendent uniquement des opérandes

- une deuxième étape rapide faisant intervenir les bits de retenue.

La première étape a lieu pendant le calcul des retenues par le circuit d'anticipation de l'additionneur, et compte tenu de la lenteur relative de ce calcul, cette première étape est conçue de façon à effectuer un maximum de calculs préparatoires, permettant ainsi de simplifier la deuxième étape rendue par conséquent plus rapide.

Dans certaines conditions, le ou les bits de parité associés à la somme peuvent avec cette réalisation être obtenus avant la somme elle-même.

Toutefois, ce dispositif présente l'inconvénient d'être assez complexe et de nécessiter un grand nombre de circuits logiques pour sa mise en oeuvre. En outre, de par sa structure, il se prête mal à une implémentation physique dans une structure régulière de type "Chemin de Données", fréquente en technologie CMOS par exemple.

Le but de cette invention est donc d'optimiser les performances en vitesse et en surface d'implantation du dispositif décrit dans le brevet ci-dessus tout en conservant le même principe de calcul de retenue par anticipation et les deux étapes susmentionnées.

Un autre but est de réduire le nombre de portes et de couches logiques dans ce dispositif.

Un autre but est d'adapter ce dispositif pour pouvoir l'implanter dans une structure régulière du type "Chemin de Données".

Un autre but est de fusionner le bloc d'anticipation des retenues et le bloc de calcul des parités de l'art antérieur.

Cette invention permet en outre de simplifier la structure de l'additionneur à anticipation de retenue.

L'invention part de la constatation que le bit de retenue entrante $c_{in}$ de l'additionneur, qui est un bit participant à l'addition et provenant par exemple d'un autre additionneur ou servant à modifier la fonction réalisée, est disponible avant même le début des calculs, au contraire des bits de retenue entrante correspondant aux autres groupes de bits des opérandes qui sont obtenus seulement en cours de calcul. Par conséquent, les circuits chargés de calculer le bit de parité associé au groupe formé des bits de poids faible du résultat peuvent faire intervenir cette retenue entrante déjà très tôt dans le cours des opérations sans ralentir le dispositif. Ces circuits peuvent donc avoir une structure simplifiée par rapport aux circuits chargés de calculer les bits de parité associés aux autres groupes. Nous verrons que cette simplification a pour conséquence que les bits de retenue entrante $c_{i,1}$ pour les autres groupes peuvent être déduits très simplement sans nécessiter de circuits de prédiction séparé.

L'invention a donc pour objet un dispositif de calcul des K bits de parité $PS_i$ associés respectivement à K groupes de m bits consécutifs extraits du résultat S de l'addition de deux nombres binaires A et B, lesdits nombres A et B comprenant chacun au moins K groupes de m bits, K étant au moins égal à 2, l'addition générant un mot de retenue C, les groupes extraits desdits nombres A,B,C et S étant formés respectivement des bits $a_{i,m}$, ..., $a_{i,j}$, ..., $a_{i,2}$, $a_{i,1}$, des bits $b_{i,m}$, ..., $b_{i,j}$, ..., $b_{i,2}$, $b_{i,1}$, des bits $c_{i,m}$, ..., $c_{i,j}$, ..., $c_{i,2}$, $c_{i,1}$ et des bits $s_{i,m}$, ..., respectivement, $s_{i,j}$, ..., $s_{i,2}$, $s_{i,1}$, l'indice i désignant un des K groupes, les groupes extraits de chaque nombre A,B,C et S constitués par les m bits de poids faibles étant désignés par un indice i = 1, et l'indice j indiquant le poids dans le groupe du bit associé, $c_{1,1}$ étant le bit de retenue entrante intervenant dans l'addition, le dispositif comprenant au moins deux étages (10', 50') de circuits, chaque étage recevant en entrée plusieurs groupes de bits extraits des opérandes ou de signaux intermédiaires calculés à partir des opérandes, un étage étant placé en aval de l'autre dans le sens de transmission des signaux dans le dispositif, chaque étage effectuant une étape distincte dans le calcul des parités PSi associées aux groupes du résultat, le premier étage (10') placé en amont de l'autre desdits au moins deux étages utilisant la valeur du bit de retenue entrante $c_{1,1}$ correspondant au groupe constitué des m bits de poids faible mais pas les valeurs des autres bits de retenue entrante $c_{i,1}$ pour i=[2,3,...,K], correspondant aux autres groupes et lesdites valeurs des autres bits de retenue intervenant seulement dans un second étage (50') placé plus en aval du premier étage (10').

Selon une autre caractéristique, l'invention a pour but un dispositif comportant un troisième étage (60) auquel sont appliqués des signaux intermédiaires ($p_{i,j}$, $g_{i,j}$) provenant dudit premier étage et appliquant au dit second étage d'autres signaux intermédiaires ($X_i$, $Y_i$) pour le calcul des bits de parité PSi associés aux groupes du résultat, la valeur des bits de retenue entrante $c_{i,1}$ (pour (i=[2,3,...,K]) pour les groupes autres que le groupe composé des m bits de poids faibles étant calculée dans ce troisième étage.

Selon une autre caractéristique, l'invention a pour but un dispositif caractérisé en ce que chaque groupe d'indice i extrait des nombres (A,B) est associé respectivement à une parité $PA_i$ et $PB_i$, et en ce que ledit dispositif comprend:

- un dit premier étage (10') pour calculer avec (i = 1) les valeurs:

$$g_{1,1} = a_{1,1} \cdot b_{1,1} + a_{1,1} \cdot c_{1,1} + b_{1,1} \cdot c_{1,1}$$

$$g_{1,j} = a_{1,j} \cdot b_{1,j} \qquad \text{pour } (j=[2,3,...,m])$$

$$p_{1,j} = a_{1,j} \oplus b_{1,j} \qquad \text{pour } (j=[2,3,...,m])$$

- un premier opérateur (60a) appartenant au dit troisième étage pour calculer avec (i = 1) pour (j=[2,3,...,m]) les valeurs $G_{1,j}$ vérifiant les équations logiques récurrentes suivantes:

$$G_{1,j} = g_{1,j} + p_{1,j} \cdot G_{1,j-1} \qquad \text{avec } G_{1,1} = g_{1,1},$$

- un deuxième opérateur (60b) appartenant au dit troisième étage pour calculer avec (i = 1):

$$Y_1 = G_{1,1} \oplus G_{1,2} \oplus ... \oplus G_{1,j} \oplus ... \oplus G_{1,m-1} \oplus PA_1 \oplus PB_1$$

la valeur $Y_1$ étant égale à la parité associée au groupe de m bits de poids faible extraits du résultat.

Selon une autre caractéristique, l'invention a pour but un dispositif caractérisé en ce que:

- ledit premier étage (10') calcule en outre pour tout couple (i,j) avec (i=[2,3,...,K]) et (j=[1,2,...,m]) les valeurs:

$$p_{i,j} = a_{i,j} \oplus b_{i,j}$$

$$g_{i,j} = a_{i,j} \cdot b_{i,j}$$

- ledit premier opérateur (60a) appartenant au dit troisième étage calcule en outre pour tout couple (i,j) avec (i=[2,3,...,K]) et (j=[2,3,...,m]) les valeurs $G_{i,j}$ et $P_{i,j}$ vérifiant les équations logiques récurrentes suivantes:

$$G_{i,j} = g_{i,j} + p_{i,j} \cdot G_{i,j-1} \qquad \text{avec } G_{i,1} = g_{i,1},$$

$$P_{i,j} = p_{i,j} \cdot P_{i,j-1} \qquad \text{avec } P_{i,1} = p_{i,1}$$

- ledit deuxième opérateur (60b) appartenant au dit troisième étage calcule en outre pour (i=[2,3,...,K]):

$$Y_i = G_{i,1} \oplus G_{i,2} \oplus ... \oplus G_{i,j} \oplus ... \oplus G_{i,m-1} \oplus PA_i \oplus PB_i$$

$$X_i = P_{i,1} \oplus P_{i,2} \oplus ... \oplus P_{i,j} \oplus ... \oplus P_{i,m-1}$$

la parité associée aux groupes de m bits extraits du résultat autres que le groupe formé des m bits de poids faible étant alors calculée par un troisième opérateur (50) appartenant au dit second étage à l'aide de la relation:

$$PS_i = Y_i \oplus c_{i,1} \cdot X_i^* \qquad \text{pour } (i=[2,3,...,K])$$

où $c_{i,1}$ est la retenue de plus faible poids du groupe d'indice i et où $X_i^*$ est le complément de $X_i$

Selon une autre caractéristique de l'invention, la retenue de plus faible poids $c_{i,1}$ (pour (i=[2,3,...,K]) utilisée par ledit troisième opérateur pour les groupes autres que le groupe de poids faible est déterminée dans ledit premier opérateur:

- pour (i = 2), comme étant égale à la valeur $G_{1,m}$ calculée à partir du groupe constitué des m bits de poids faible
- pour (i=[3,4,...,K]), en appliquant aux entrées d'un module d'un troisième type (M3) les sorties $P_{i-1,m}$ et $G_{i-1,m}$ provenant du premier opérateur ainsi que la retenue entrante $c_{i-1,1}$ du groupe de poids immédiatement inférieur, la sortie du module M3 fournissant la valeur:

$$c_{i,1} = G_{i-1,m} + P_{i-1,m} \cdot c_{i-1,1}$$

Selon une autre caractéristique de l'invention, la partie du premier opérateur chargée du traitement des groupes constitués des m bits de poids faible utilise des modules d'un premier type (M1) et des modules d'un troisième type (M3), les modules d'un premier type opérant sur quatre entrées Px, Gx, Py, Gy et fournissant deux sorties Pz, Gz liées aux entrées par les relations suivantes:

$$Pz = Py \cdot Px$$

$$Gz = Gy + Py \cdot Gx,$$

les modules d'un troisième type opérant sur trois entrées Px, Gx et cy et fournissant une sortie cz vérifiant la relation:

$$cz = Gx + Px \cdot cy$$

lesdits modules étant montés conformément à la méthode récurrente suivante:

a) Pour j = 1, on obtient directement $G_{1,1} = g_{1,1}$
b) Pour j = 2, un premier module M3 (1') opère sur $p_{1,2}$, $g_{1,2}$ et $g_{1,1}$ et fournit $G_{1,2}$
c) Pour j compris entre 3 et 4, un second module M1 (2') opère sur $p_{1,3}$, $g_{1,3}$ et $p_{1,4}$, $g_{1,4}$, un troisième module M3 (3') opère sur $G_{1,2}$ et $p_{1,3}$, $g_{1,3}$ et fournit $G_{1,3}$, un quatrième module M3 (4') opère sur $G_{1,2}$ et les sorties du deuxième module (2') et fournit $G_{1,4}$
d) le montage initial pour j compris entre 1 et $2^n$ étant réalisé, le montage pour j compris entre $2^n+1$ et $2^{n+1}$ est obtenu en ajoutant des modules M1 disposés selon ledit montage initial mais décalés de $2^n$ rangs vers les poids forts, fournissant ainsi de nouvelles sorties, $2^n$ sorties du troisième type (M3) supplémentaires étant disposés pour opérer sur les sorties du plus fort poids $G_{1,2^n}$ issues dudit montage initial et respectivement chacune desdites nouvelles sorties.

Selon une autre caractéristique de l'invention, la partie dudit deuxième opérateur (61b) chargée du traitement des groupes constitués des m bits de poids faible est constitué de portes logiques de type "OU EXCLUSIF" disposés en arbre qui reçoit en entrée les sorties $G_{1,j}$ jusqu'à $G_{1,m-1}$ du premier opérateur, les parités PA1 et PB1 associées aux groupes des opérandes constitués des m bits de poids faible ainsi que la retenue entrante $c_{1,1}$, ces signaux étant pris deux à deux autant que possible, et les portes logiques étant disposées de manière à calculer

$$Y_1 = PA1 \oplus PB1 \oplus c_{1,1} \oplus G_{1,1} \oplus G_{1,2} \oplus ... \oplus G_{1,j} \oplus ... \oplus G_{1,m-1}$$

Selon une autre caractéristique de l'invention, ledit premier étage (10') peut être commun avec ou distinct de l'additionneur associé audit dispositif.

D'autres caractéristiques et avantages vont apparaître à l'aide de la description qui suit, donnée à titre d'exemple et illustrée dans les figures annexées.

- La figure 1 représente un schéma d'ensemble comprenant un additionneur et un dispositif de calcul des bits de parité selon l'art antérieur.
- La figure 2 représente un dispositif de calcul du bit de parité associé à un groupe de huit bits extrait d'une somme de deux nombres binaires selon l'art antérieur.
- La figure 3 représente un circuit d'anticipation des bits de retenue selon un mode de réalisation particulier de l'art antérieur.
- La figure 4 représente un schéma d'ensemble comprenant un additionneur et un dispositif de calcul des bits de parité selon l'invention.
- La figure 5 représente un circuit d'additionneur modifié selon l'invention.
- La figure 6 représente un circuit de calcul des deux bits de parité associés à deux groupes de huit bits de poids faible extraits de la somme de deux nombres binaires selon l'invention.
- La figure 7 représente un module M1 utilisé dans l'invention.
- La figure 8 représente un module M2 utilisé dans l'invention.
- La figure 9 représente un module M3 utilisé dans l'invention.

Tout au long de la description, les mêmes éléments dans les diverses figures sont désignés par les mêmes références numériques.

Avant de décrire l'invention en référence aux figures, il convient d'indiquer les bases théoriques de l'invention. Tout au long de la description, le lecteur est invité à se référer au brevet déjà mentionné ci-dessus EP329545, qui décrit en détail un art antérieur rappelé ici de manière plus succinte.

De manière générale, le calcul de la somme de deux nombres A et B de N bits, constitués respectivement des bits $a_N$, $a_{N-1}$, ..., $a_i$, ..., $a_2$, $a_1$ et $b_N$, $b_{N-1}$, ..., $b_i$, ..., $b_2$, $b_1$ génère un mot de retenue C formé des bits de retenue $c_i$ et une somme S formée des bits $s_i$. Considérons maintenant des groupes formés de m bits consécutifs extraits des nombres A, B, C et S et constitués respectivement des bits $a_{i,j}$, $b_{i,j}$, $c_{i,j}$ et $s_{i,j}$. i est l'indice de groupe, le groupe d'indice 1, parfois appelé par la suite groupe de poids faible, étant constitué des m bits de poids faibles du mot, et j indique le poids du bit dans son groupe.

Pour préciser les notations, écrivons sous une forme habituelle l'opération effectuée lors de l'addition de deux groupes homologues Ai et Bi correspondant à deux opérandes A et B, le groupe ayant pour cet exemple une taille m = 4 bits:

$$c_{i,5}\ c_{i,4}\ c_{i,3}\ c_{i,2}\ c_{i,1}$$
$$a_{i,4}\ a_{i,3}\ a_{i,2}\ a_{i,1}$$
$$+\quad b_{i,4}\ b_{i,3}\ b_{i,2}\ b_{i,1}$$
$$\overline{\qquad\qquad\qquad}$$
$$s_{i,4}\ s_{i,3}\ s_{i,2}\ s_{i,1}$$

$c_{i,1}$ étant la retenue entrante du groupe i. Pour le groupe constitués des m bits de poids faibles (i=1), $c_{1,1}$ est égal à la retenue entrante dans l'additionneur, désignée $c_{in}$. La retenue $c_{i,5}$ est égale à la retenue entrante $c_{i+1,1}$ du groupe de poids immédiatement supérieur. Pour le groupe constitués des m bits de poids fort, $c_{i,5}$ est égal à la variable de débordement de l'additionneur.

Par la suite, les indices de groupe i ne seront mentionnés que lorsque cela sera nécessaire.

Lorsque cela facilitera la compréhension sans ajouter d'ambiguïté, les indices ne se rapporteront plus au poids des bits à l'intérieur d'un groupe de m bits, mais à leur poids à l'intérieur du mot complet formé de la juxtaposition de tous les groupes. Nous écrirons par exemple indifféremment pour désigner le j-ème bit du i-ème groupe de la variable x: $x_{i,j}$ ou $x_{(i-1)m+j}$. Par exemple, si les groupes ont une taille m = 8 bits, le troisième bit du deuxième groupe de l'opérande A sera désigné selon ce qui est le plus explicite $a_{2,3}$ ou $a_{11}$. Si l'appartenance à un groupe particulier n'est pas significative, nous écrirons $a_{i,3}$ ou simplement $a_3$.

Un type d'additionneur connu utilise un circuit d'anticipation du mot de retenue.

Les additionneurs de ce type comprennent un premier étage qui forme des variables intermédiaires $p_j$ et $g_j$ calculées à partir des bits $a_j$, $b_j$ des deux nombres A et B selon les équations suivantes:

$$p_j = a_j \oplus b_j$$

$$g_j = a_j \cdot b_j$$

$\oplus$ désignant l'opération "OU EXCLUSIF"

Le bit de poids j de la somme est obtenu à partir de la retenue $c_j$ de poids j par l'équation:

$$s_j = p_j \oplus c_j$$

D'autre part, on a:

$$c_j = g_{j-1} \oplus p_{j-1} \cdot c_{j-1}$$

avec

$$c_1 = c_{in}$$

Ainsi les bits de retenue peuvent être calculés de proche en proche à partir des variables $p_j$, $g_j$ qui dépendent des seuls bits $a_j$, $b_j$ des opérandes. Ce calcul est effectué par le circuit d'anticipation des retenues que nous allons décrire ci-dessous. L'additionneur comporte alors un dernier étage de calcul des bits $s_i$ de la somme S obtenus par la formule $s_j = p_j \oplus c_j$.

Considérons maintenant des groupes formés des bits consécutifs extraits des nombres A, B et C et constitués respectivement des bits $a_j$, $b_j$ et $c_j$ où j indique le poids du bit dans son groupe. En désignant par $c_{i,1}$ le bit de retenue de plus faible poids dans le groupe d'indice i, on peut démontrer qu'on a pour j supérieur à 1 :

$$c_{j+1} = G_j + P_j \cdot c_{i,1}$$

où $P_j$ et $G_j$ sont définis par les formules récurrentes suivantes:

$$P_j = p_j \cdot P_{j-1} \qquad \text{avec } P_1 = p_1$$

$$G_j = g_j + p_j \cdot G_{j-1} \qquad G_1 = g_1$$

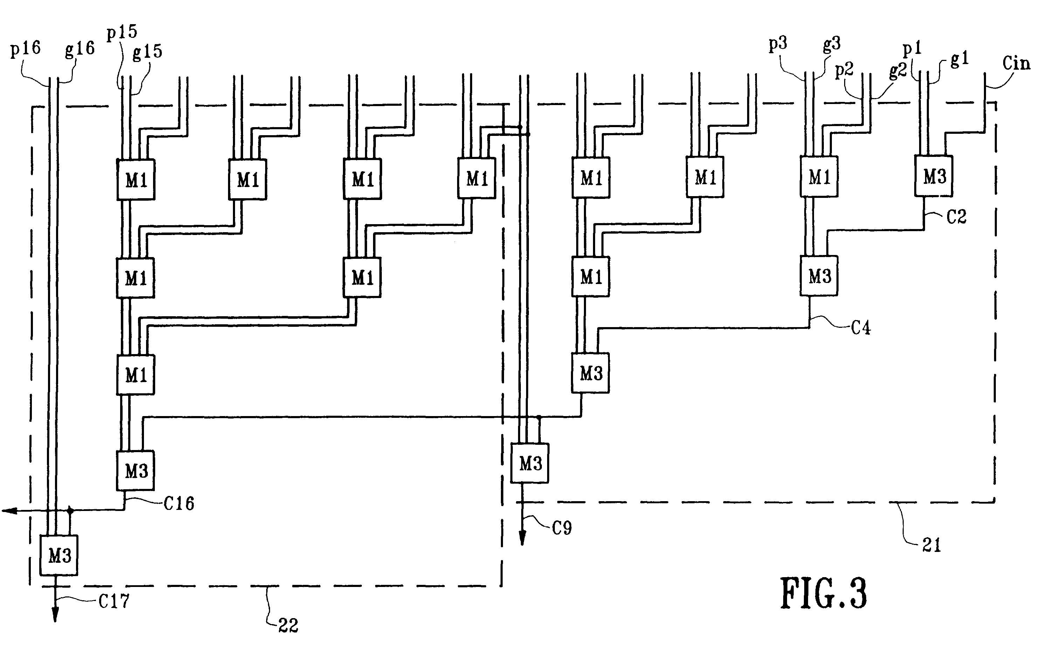

Ces formules permettent de construire un circuit d'anticipation des retenues ayant un nombre réduit de circuits logiques branchés en cascade. Nous y reviendrons en relation avec la figure 3 tirée de l'art antérieur.

Concernant maintenant le problème des bits de parité, nous avons vu que les nombres sont généralement considérés comme formés de plusieurs groupes de m bits de même taille et qu'à chaque groupe on associe un bit de parité.

Ainsi les opérandes A et B, le mot de retenue C et la somme S sont par exemple constitués respectivement des groupes A1, A2, A3, A4, des groupes B1, B2, B3, B4, des groupes C1, C2, C3, C4 et des groupes S1, S2, S3, S4. A chaque groupe, par exemple Ai, on associe un bit de parité, par exemple $PA_i$.

Dans la suite de l'exposé, en ce qui concerne les bits de parité, nous considérerons uniquement les groupes homologues des opérandes, du mot de retenue et de la somme, c'est-à-dire les groupes constitués des bits de même poids. Si nous désignons par $PA_i$, $PB_i$, $PS_i$ les bits de parité associés respectivement à des groupes homologues tirés des nombres A, B et S, il est facile de démontrer que l'on a la relation:

$$PS_i = PA_i \oplus PB_i \oplus PC_i$$

avec $PC_i = c_{i,m} \oplus ... \oplus c_{i,j} \oplus ... \oplus c_{i,2} \oplus c_{i,1}$

$PC_i$ est le bit de parité associé au groupe d'indice i extrait du mot formé par les bits de retenue intervenant lors de l'addition. Il apparaît que pour obtenir $PC_i$ selon la formule précédente, on doit disposer de toutes les retenues. Cependant, des calculs théoriques montrent que $PC_i$ peut se mettre sous la forme:

$$PC_i = Y_i \oplus c_{i,1} \cdot X_i^*$$

où $c_{i,1}$ est la retenue de plus faible poids du groupe d'indice i et où $X_i^*$ est le complément de $X_i$, avec:

$$Y_i = G_{i,1} \oplus G_{i,2} \oplus \ldots \oplus G_{i,j} \oplus \ldots \oplus G_{i,m-1}$$

$$X_i = P_{i,1} \oplus P_{i,2} \oplus \ldots \oplus P_{i,j} \oplus \ldots \oplus P_{i,m-1}$$

et où les variables $P_{i,j}$ et $G_{i,j}$ vérifient les formules de récurence suivantes:

$$(1) \qquad P_{i,j} = p_{i,j} \cdot P_{i,j-1} \qquad \text{avec } P_{i,1} = p_{i,1}$$

$$(2) \qquad G_{i,j} = g_{i,j} + p_{i,j} \cdot G_{i,j-1} \qquad G_{i,1} = g_{i,1}$$

Pour le groupe constitué par les m bits de faible poids du mot, nous avons $c_{1,1} = c_{in}$. Lorsqu'une addition normale, sans retenue entrante, est effectuée, nous avons $c_{in} = 0$. La retenue entrante $c_{in}$ vaut par exemple 1 dans le cas d'une incrémentation ou de l'utilisation de l'additionneur pour effectuer une soustraction. En effet, effectuer l'opération de soustraction A-B revient à calculer A+B*+1, B* étant le complément de B.

Nous allons maintenant décrire plus en détail l'exploitation des formules précédentes dans l'art antérieur selon le brevet susmentionné EP329545.

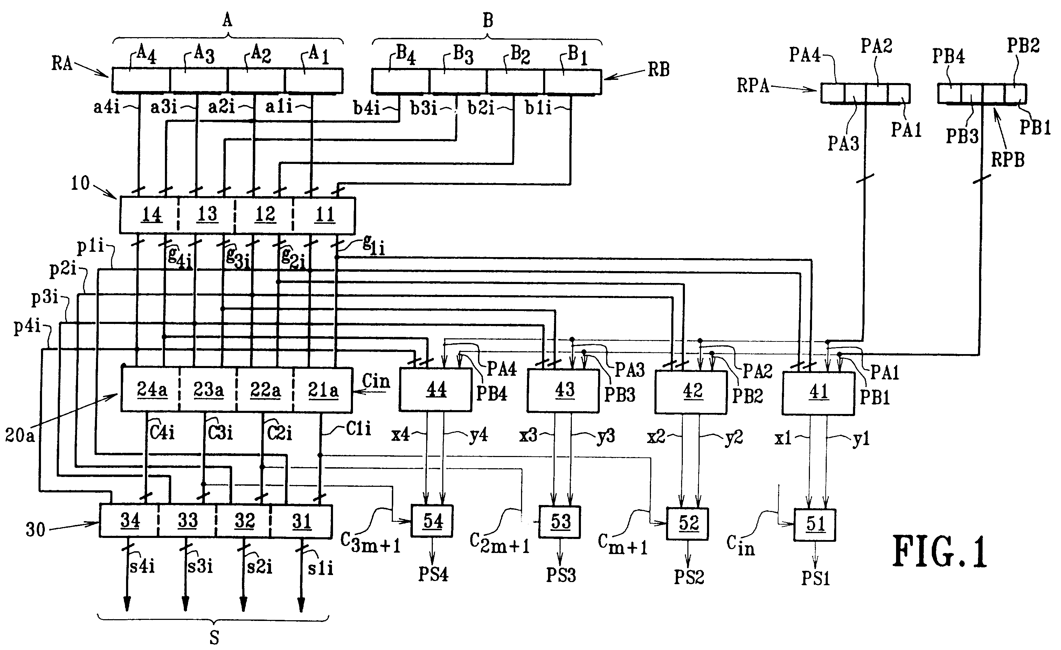

La figure 1 représente un additionneur associé à un générateur de bits de parité selon l'art antérieur.
A titre d'exemple, nous avons supposé que les nombres à additionner A et B sont constitués de quatre groupes de huit bits, respectivement A1, A2, A3, A4 et B1, B2, B3, B4. Chaque groupe est associé à un bit de parité correspondant. Par exemple, le groupe A1 est associé au bit de parité $PA_1$, le groupe A2 est associé au bit de parité $PA_2$, etc...

Les opérandes A et B ainsi que les bits de parité associés à ces deux opérandes sont contenus dans des registres respectifs RA, RB, RPA et RPB.
Nous allons maintenant considérer deux groupes homologues extraits des opérandes, par exemple A1 et B1. Le groupe A1 est constitué de m bits $a_{1i}$ et le groupe B1 est constitué de m bits $b_{1i}$. Les bits de même poids $a_{1i}$ et $b_{1i}$ sont combinés dans un opérateur 11 comprenant des circuits "OU EXCLUSIF" et des circuits "ET" de façon à calculer les variables:

$$p_{1,i} = a_{1,i} \oplus b_{1,i}$$

$$g_{1,i} = a_{1,i} \cdot b_{1,i}$$

Les circuits 12,13,14 associés aux autres groupes sont identiques au circuit 11, l'ensemble de ces circuits formant le premier étage 10 de l'additionneur.
Un circuit d'anticipation des retenues 20a reçoit en entrée les sorties du premier étage 10. Le circuit 20a permet de calculer toutes les retenues $c_{1,i}$, $c_{2,i}$, $c_{3,i}$ et $c_{4,i}$ intervenant dans l'addition des deux opérandes. Ce circuit 20a peut être considéré comme constitué de plusieurs circuits 21a, 22a, 23a et 24a associés respectivement aux groupes dont sont formés les opérandes.
Un dernier étage 30 constitué de "OU EXCLUSIF" reçoit en entrée les sorties du premier étage 10. Le circuit 30 délivre en sortie les bits $s_{1,i}$ à $s_{4,i}$ du résultat S de l'addition. Le circuit 30 peut aussi être considéré comme constitué de plusieurs circuits 31, 32, 33, 34 associés respectivement aux groupes dont sont formés les opérandes. Ainsi, le circuit 31 délivre les bits $s_{1,i}$ du groupe de poids faible vérifiant l'équation:

$$s_{1,i} = p_{1,i} \oplus c_{1,i}$$

Ce qui précède concerne exclusivement l'additionneur et nous allons maintenant décrire la partie du circuit qui concerne le générateur de parité de l'art antérieur. Le générateur de parité comprend dans cet exemple un ensemble constitué de quatre opérateurs 41, 42, 43 et 44 recevant respectivement les bits de parité des groupes homologues des opérandes et les variables issues du premier étage 10. Par exemple, l'opérateur 41 associé au groupe de poids faible reçoit les parités $PA_1$, $PB_1$ et les variables $p_{1,i}$ et $g_{1,i}$ issues du circuit 11. En fonction de ces signaux, l'opérateur 41 délivre les deux variables $X_1$ et $Y_1$ vérifiant les équations qui ont été exposées précédemment.

De façon analogue, les circuits 42, 43, 44 délivrent respectivement les variables $X_2$, $Y_2$; $X_3$, $Y_3$; $X_4$, $Y_4$.

Un dernier étage constitué des opérateurs 51, 52, 53 et 54 reçoit les variables $X_i$, $Y_i$ du groupe correspondant ainsi qu'un signal de retenue dépendant du groupe considéré. Plus précisément, l'opérateur 54 reçoit la retenue $c_{3m+1}$ issue du circuit 23a et qui est la retenue de plus faible poids du groupe d'indice i=4. L'opérateur 53 reçoit la retenue $c_{2m+1}$ qui est la retenue de plus faible poids du groupe d'indice i=3, et l'opérateur 52 reçoit la retenue $c_{m+1}$ qui est la retenue de plus faible poids du groupe d'indice i=2. L'opérateur 51 reçoit la retenue entrante $c_{in}$.

D'une façon générale, en désignant par $c_{i,1}$ la retenue appliquée à l'opérateur correspondant, chaque opérateur délivre un signal de sortie $PS_1...PS_4$ vérifiant:

$$PS_i = Y_i \oplus c_{i,1} \cdot X_i^*$$

Les variables $PS_1$ à $PS_4$ ainsi obtenues sont donc les bits de parité associés à chacun des groupes extraits de la somme.

Les étages 10 et 30 de l'additionneur sont constitués de circuits logiques classiques du type "ET" et "OU EXCLUSIF". Leur réalisation est à la portée de l'homme du métier et ne sera donc pas décrite en détail.

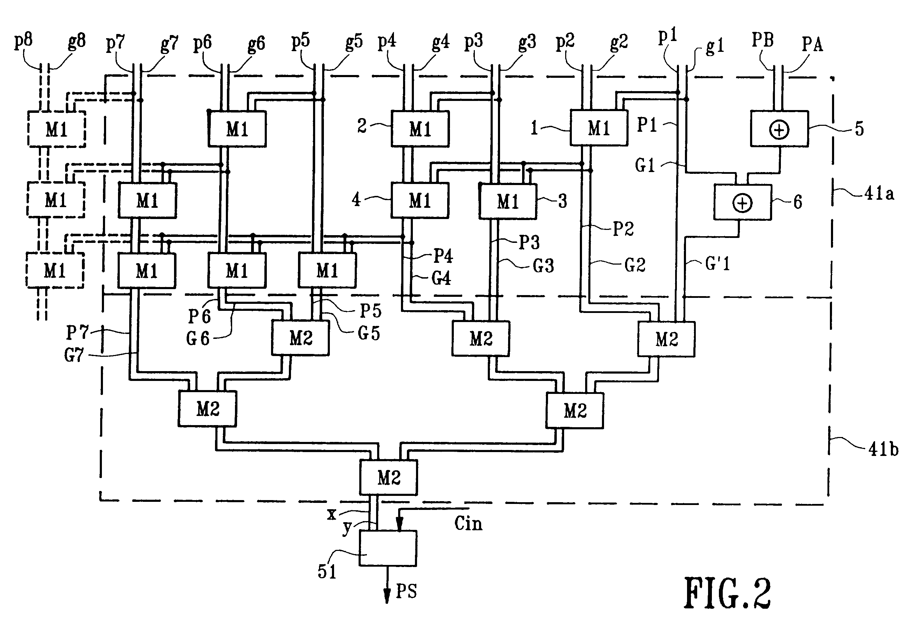

Les opérateurs 41 à 44 ainsi que le circuit d'anticipation des retenues 20a sont difficile à intégrer en technologie CMOS en utilisant la méthode du "chemin de données". L'un des avantages importants de l'invention par rapport à cette solution est la simplification et le fusionnement de ces blocs fonctionnels. Pour bien comprendre les avantages apportés et également pour mieux saisir le fonctionnement de l'invention, le fonctionnement de ces opérateurs, bien qu'appartenant à l'art antérieur, sera maintenant exposé à l'aide des figures 2 et 3.

Etant donné que, dans cette réalisation, les opérateurs 41 à 44 sont identiques, il suffira donc d'en décrire un, par exemple l'opérateur 41. Pour assurer la généralité, toute cette partie de la description sera effectuée en indiquant les diverses variables avec des indices de groupes i, i valant 1 dans le cas des variables traitées par l'opérateur 41. Les relations évoquées dans cette section peuvent donc sans autre être généralisées pour des valeurs i=[1,2,...,m].

La figure 2 représente un élément 41 du circuit permettant le calcul du bit de parité associé au groupe constitué des 8 bits de poids faible du résultat d'une addition de deux nombres. Il est clair que la description qui va suivre ne se limite pas à ce cas particulier et que le circuit pourrait se généraliser pour un nombre quelconque de bits.

Le circuit de la figure 2 comprend un premier opérateur 41a recevant les variables $p_{i,1}$, $g_{i,1}$ à $p_{i,7}$, $g_{i,7}$ calculées par le circuit 11 exposé précédemment ou par un circuit séparé ou identique. Ce circuit 11 peut en effet être commun avec l'additionneur mais si on veut améliorer l'integrité du circuit, il est préférable d'utiliser un circuit 11 indépendant de l'additionneur car l'utilisation d'un circuit 11 commun masquerait les erreurs qui pourraient se produire dans ce circuit. L'opérateur 41a est constitué exclusivement de modules logiques d'un premier type M1 recevant en entrée quatre variables binaires $P_x$, $G_x$, $P_y$, $G_y$ et fournissant deux variables binaires de sortie Pz, Gz vérifiant les équations suivantes:

$$P_z = P_y \cdot P_x$$

$$G_z = G_y + P_y \cdot G_x$$

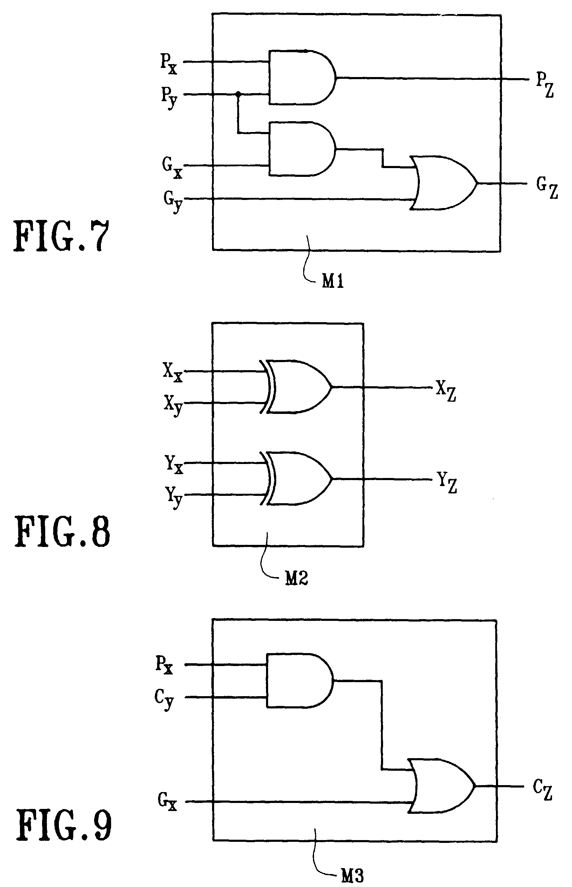

La figure 7 montre un exemple de réalisation d'un module M1 à l'aide d'éléments logiques de type "ET", "OU". Il est évident que d'autres réalisations par exemple à l'aide d'éléments de type "NON-ET", "NON-OU", "NON OU-EXCLUSIF" adaptés à la technologie CMOS, sont à la portée de l'homme de l'art.

L'utilisation de ces modules et leur disposition vont permettre de calculer les varibles $P_{i,j}$ et $G_{i,j}$, pour (j=[1,2,..., 7]), définis par les relations de récurrence:

$$P_{i,j} = p_{i,j} \cdot P_{i,j-1} \qquad \text{avec } P_{i,1} = p_{i,1}$$

$$G_{i,j} = g_{i,j} + p_{i,j} \cdot G_{i,j-1} \qquad \text{avec } G_{i,1} = g_{i,1}$$

La relation qui lie le couple de variables de sortie Pz, Gz aux deux couples de variables d'entrée $P_x$, $G_x$ et $P_y$, $G_y$ possède l'importante propriété d'être associative. Grâce à cette propriété, il est possible de disposer les modules M1 de façon à calculer les variables $P_{i,j}$ et $G_{i,j}$ tout en minimisant le nombre de couches de ce circuit, c'est-à-dire le nombre de ces modules mis en cascade.

La façon de construire le premier opérateur 41a, par une méthode récursive, est indiquée dans le brevet susmentionné EP329545.

Pour j = 1, on obtient directement $P_{i,1} = p_{i,1}$ et $G_{i,1} = g_{i,1}$. Pour j = 2, on combine en outre $p_{i,1}$, $g_{i,1}$ avec $p_{i,2}$, $g_{i,2}$ dans un premier module 1 qui fournit en sortie $P_{i,2}$, $G_{i,2}$. pour j = 3, un troisième module 3 combine $p_{i,3}$, $g_{i,3}$ avec $P_{i,2}$, $G_{i,2}$ issus du premier module 1. Ce module 3 fournit $P_{i,3}$, $G_{i,3}$. Pour j = 4, un autre module 2 combine $p_{i,3}$, $g_{i,3}$ et $p_{i,4}$, $g_{i,4}$ et la sortie de ce module 2 est combinée dans un autre module 4 avec la sortie du module 1. Ce module 4 fournit $P_{i,4}$, $G_{i,4}$. On obtient bien ce résultat grâce à l'associativité de la fonction réalisée par le module M1.

Pour compléter la construction de l'opérateur 41 a pour j supérieur à 4, il suffit de suivre la méthode suivante:

le montage initial pour j compris entre 1 et $2^n$ étant réalisé, le montage pour j compris entre $2^n+1$ et $2^{n+1}$ est obtenu en ajoutant des modules M1 disposés selon ce montage initial mais décalés de $2^n$ rangs vers les poids forts, fournissant ainsi de nouvelles sorties. On dispose ensuite $2^n$ modules M1 supplémentaires qui combinent les sorties de plus fort poids $P_{i,2n}$, $G_{i,2n}$ issues du montage initial et, respectivement, chacune de ces nouvelles sorties.

La construction s'arrêtera à l'ordre m-1. On disposera alors de toutes les valeurs des variables $P_i$ et $G_i$. Dans l'exemple considéré, nous disposons donc en sortie du premier opérateur 41a des variables $P_{i,j}$, $G_{i,j}$ jusqu'à l'ordre 7.

Les sorties $P_{i,j}$, $G_{i,j}$ de l'opérateur 41a sont ensuite appliquées aux entrées du second opérateur 41b.

L'opérateur 41b est composé de modules logiques d'un second type M2 qui sont simplement des circuits "OU EXCLUSIF" doubles à quatre entrées $X_x$, $Y_x$, $X_y$, $Y_y$ et fournissant deux sorties Xz, $Y_z$ vérifiant:

$$X_z = X_x \oplus X_y$$

$$Y_z = Y_x \oplus Y_y$$

La figure 8 montre un exemple de réalisation d'un module M2 à l'aide d'éléments logiques de type "OU-EXCLUSIF". A nouveau, d'autres réalisations à partir d'éléments mieux adaptés à une technologie particulière sont à la portée de l'homme de l'art.

On voit donc immédiatement qu'il suffit de disposer ces modules M2 selon une construction en pyramide inversée qui est équivalente à un opérateur "OU EXCLUSIF" à entrées multiples. Ce montage permet donc d'obtenir les deux variables X et Y' définies par les relations:

$$Y_i' = G'_{i,1} \oplus G_{i,2} \oplus ... \oplus G_{i,j} \oplus ... \oplus G_{i,m-1}$$

$$X_i = P_{i,1} \oplus P_{i,2} \oplus ... \oplus P_{i,j} \oplus ... \oplus P_{i,m-1}$$

$G'_{i,1}$ étant calculé selon la relation $G'_{i,1} = PA_i \oplus PB_i \oplus G_{i,1}$. On comprendra plus loin la raison de l'introduction de $PA_i$, $PB_i$ dans le calcul de $Y_i'$.

Les variables $X_i$, $Y_i'$ et la retenue $c_{i,1}$ (pour i = 1, $c_{1,1} = c_{in}$) définie précédemment sont appliquées au troisième opérateur 51 dont la sortie $PS_i$ est liée aux entrées par l'équation logique:

$$PS_i = Y_i' \oplus c_{i,1} \ X_i^*$$

où $X_i^*$ est le complément de $X_i$.

Si l'on définit une grandeur $PC_i$ par la relation

$$PC_i = c_{i,1} \oplus c_{i,2} \oplus ... \oplus c_{i,j} \oplus ... \oplus c_{i,m}$$

alors on a:

$$PS_i = PA_i \oplus PB_i \oplus PC_i,$$

c'est-à-dire que la parité du résultat d'une addition de deux nombres binaires est égale à la parité du mot de retenue ou-exclusif la parité des deux opérandes de l'addition. Le circuit précédent dans lequel on n'aurait pas remplacé $G_{i,1}$ par $G'_{i,1}$ fournirait donc en sortie la parité du mot de retenue au lieu de la parité du résultat. Il aurait également été possible de remplacer n'importe laquelle des sorties $G_{i,j}$ du premier opérateur par l'expression $PA_i \oplus PB_i \oplus G_{i,j}$. Une autre solution aurait été de remplacer deux sorties quelconques $G_{i,j}$ et $G_{i,k}$ du premier opérateur par respectivement le résultat des opérations $PA_i \oplus G_{i,j}$ et $PB_i \oplus G_{i,k}$. Tout cela est très détaillé dans le brevet susmentionné.

La figure 3 représente un circuit d'anticipation des retenues spécifiques au générateur de parité selon l'art antérieur. Il fournit les retenues d'ordre $c_9$, $c_{17}$ et $c_{25}$ servant d'entrée respectivement aux circuits 52, 53 et 54 du troisième étage, c'est-à-dire les variables $c_{2,1}$, $c_{3,1}$ et $c_{4,1}$. Ce circuit étant dans l'invention devenu inutile, la description de son fonctionement, expliquée en détail dans le brevet susmentionné, n'est pas reprise ici.

La solution de l'art antérieur décrite jusqu'ici, outre sa complexité, présente l'inconvénient de s'implémenter difficilement en technologie CMOS. En particulier, une implantation physique dans une structure régulière de type "Chemin de donnée" est loin d'être optimale. Les différents blocs logiques utilisés avec ce type d'implantation doivent au long d'un chemin de donnée tous avoir la même largeur, dépendant du nombre de bits du chemin. Par exemple, un chemin pourra être constitué d'un registre 32 bits, suivi d'une pile 32 bits puis d'un incrémenteur 32 bits. Lorsque ces différents blocs ont tous la même largeur, l'implantation par superposition peut être réalisée très avantageusement en terme de surface de silicium utilisée et de longueurs des interconnexions.

Le circuit représenté sur la figure 1 est cependant très difficile à implanter dans ce type de structure, sauf en lui donnant une hauteur exagérée et donc des longueurs d'interconnexion incompatibles avec la nécessité d'un traitement à grande vitesse.

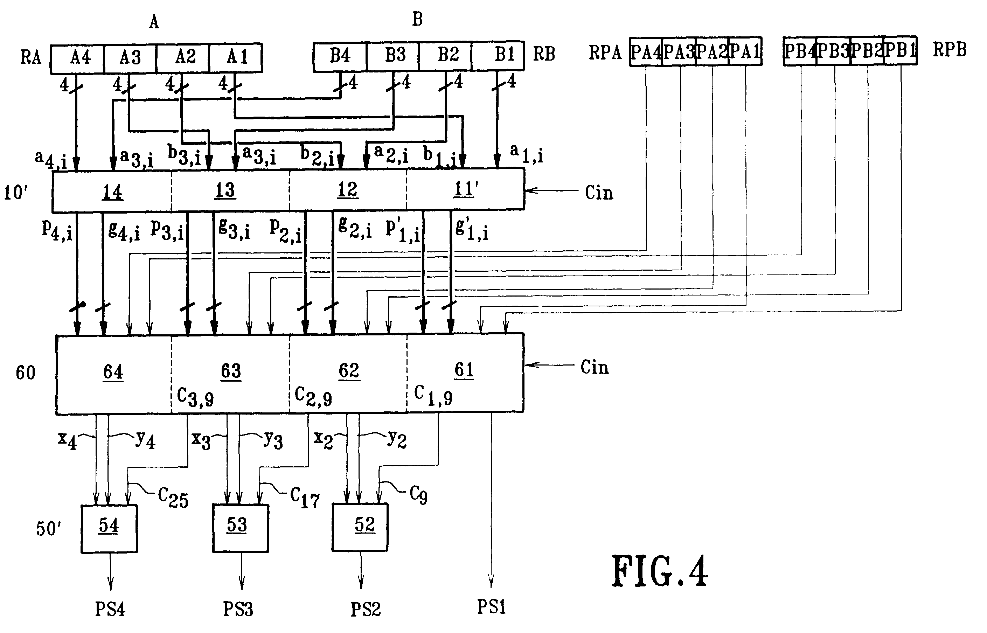

Ce problème et celui de la complexité du dispositif décrit ci-dessus sont résolus par le circuit décrit maintenant en relation avec les figures 4 à 6.

Pour les opérations sur le groupe de données constitués des m bits consécutifs de poids faible ($A_1$, $B_1$, $C_1$ et $S_1$), désigné comme le groupe de poids faible, la retenue $c_{1,1}$ est disponible avant même le début des calculs des variables $G_{1,j}$ et $P_{1,j}$, puisqu'il s'agit de la retenue entrante dans l'additionneur $c_{in}$. Il n'est donc pas nécessaire de ne faire intervenir cette variable que tout à la fin des opérations de calcul.

L'invention propose donc de faire intervenir cette retenue très rapidement, en l'incluant dans le calcul du signal g de poids le plus faible $g'_{1,1}$.

La figure 4 représente un dispositif de calcul des parités d'une somme selon l'invention. Ce schéma est à comparer avec le schéma de la figure 1 correspondant à l'art antérieur.

Le premier étage 10' est modifié dans l'invention par rapport à l'étage 10 de l'art antérieur. Les nouvelles variables $g'_{1,j}$ et $p'_{1,j}$ sont calculées selon les relations:

$$g'_{1,1} = a_{1,1} \cdot b_{1,1} + a_{1,1} \cdot c_{in} + b_{1,1} \cdot c_{in}$$

$$p'_{1,1} = a_{1,1} \oplus b_{1,1} \oplus c_{in}$$

Le premier indice indique selon la convention adoptée plus haut le groupe de bits concerné par cette modification (c'est-à-dire ici le groupe de poids faible A1, B1, C1 et S1).

Les autres valeurs de $g_{i,j}$ et de $p_{i,j}$ sont inchangées et prennent les mêmes valeurs que dans la réalisation de l'art antérieur:

$$g_{i,j} = a_{i,j} \cdot b_{i,j} \qquad \text{pour tout couple (i,j) avec}$$

$$((i = 1), j = [2,3,...,m]))$$

$$\text{ou } ((i = [2,3,...,K]), j = [1,2,...,m])$$

$$p_{i,j} = a_{i,j} \oplus b_{i,j} \qquad \text{pour tout couple (i,j) avec}$$

$$((i = 1), j = [2,3,...,m]))$$

$$\text{ou } ((i = [2,3,...,K]), j = [1,2,...,m])$$

$g'_{1,1}$ prend la valeur 1 lorsque deux au moins des variables $a_{1,1}$, $b_{1,1}$ et $c_{in}$ prennent la valeur 1. On a donc $g'_{1,1} = c_{1,2}$. En outre, $p'_{1,1}$ prend la valeur 1 lorsque une ou trois des variables $a_{1,1}$, $b_{1,1}$ et $c_{in}$ prennent la valeur 1. On a donc $p'_{1,1} = s_{1,1}$.

Le nouvel étage 10' modifié est constitué de circuits logiques classiques de type "ET", "OU" et "OU EXCLUSIF" ou d'autres circuits adaptés à une technologie particulière. Seul la partie 11' est modifiée par rapport au brevet susmentionné, les blocs 12, 13 et 14 sont identiques. Sa réalisation est à la portée de l'homme de l'art et ne sera donc pas décrite en détail.

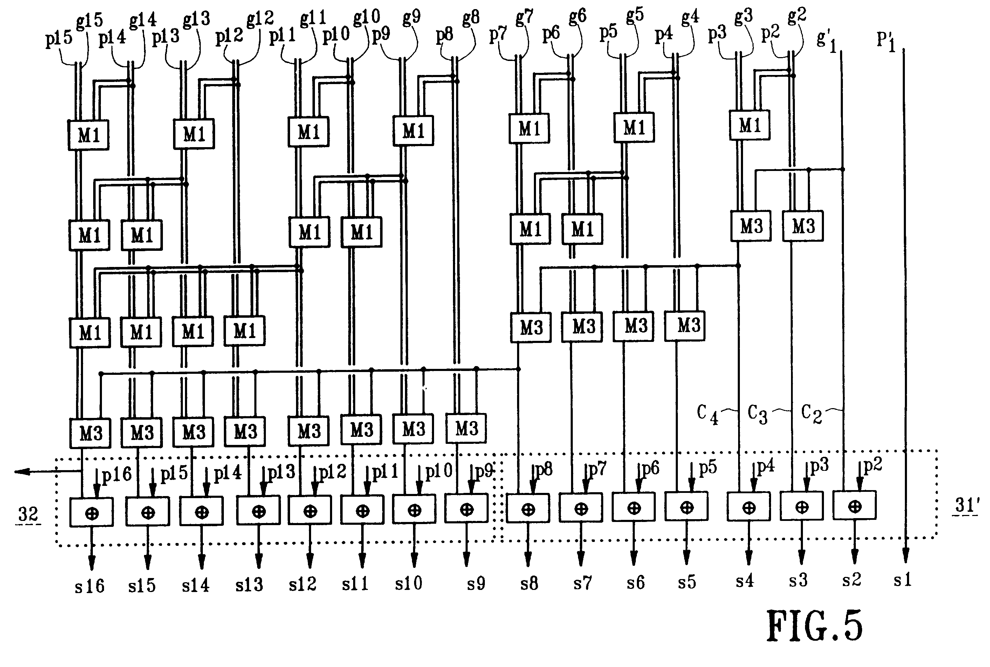

La figure 5 représente le nouvel additionneur modifié pour utiliser ces variables d'entrée. Les bits $s_i$ du résultat S de l'addition sont calculés avec la relation classique:

$$s_i = p_i \oplus c_i \qquad \text{pour } i = [2,3,...,K*m]$$

les retenues $c_i$ étant obtenues par la relation:

$$c_1 = c_{in}$$

$$c_i = G_{i-1} + P_{i-1} \cdot C_{i-1} \qquad \text{pour } i = [2,3,...,K*m]$$

Le circuit de la figure 4 utilise des modules de type M3 à trois entrées Px, Gx, cy et à une sortie cz vérifiant la relation:

$$cz = Gx + Px \cdot cy$$

La figure 9 montre un exemple de réalisation d'un modèle M3 à l'aide d'éléments logiques de type "ET", "OU". A nouveau, l'homme de l'art saura imaginer d'autres réalisations à l'aide d'éléments mieux adaptés à une techonologie particulière.

Les modules de type M1 et M3 sont disposés selon un montage appelé "recurrence solver" connu dans la technique des additionneurs, et que nous ne décrirons pas en détail ici. Notons seulement que les valeurs $c_{1,2} = g'_{1,1}$ et $s_{1,1} = p'_{1,1}$ directement disponibles à la sortie du bloc 10' modifié permettent une simplification de la structure de l'additionneur par rapport à l'art antérieur. Le bloc 31' qui effectue l'addition du groupe de poids faible A1 et B1, donnant le résultat S1, utilise une porte "OU EXCLUSIF" et un module M3 de moins que le circuit correspondant de l'art antérieur. Les autres blocs 32, 33 et 34 sont inchangés.

Les valeurs $p_{i,j}$ et $g_{i,j}$ ou $p'_{i,j}$ et $g'_{i,j}$ sont également introduites dans un étage de calcul des parités 60. Cet étage remplace à la fois les blocs 21 à 24 d'anticipation des retenues spécifique au générateur de parité et les blocs 41 à 44 de calcul de bits de parité mentionnés dans le brevet susmentionné de l'art antérieur. L'étage 60 reçoit en outre les bits de parité $PA_i$ et $PB_i$ associés aux opérandes A et B respectivement. Ces bits de parité $PA_i$ et $PB_i$ proviennent de deux registres RPA et RPB respectivement, et, dans l'exemple, sont constitués de 4 bits $PA_1$ à $PA_4$ et $PB_1$ à $PB_4$ respectivement, chaque bit indiquant la parité associée à un des quatre groupes de huit bits constituant les deux opérandes. L'étage 60 reçoit en outre une variable $c_{in} = c_{1,1}$ qui est la retenue entrante dans l'additionneur.

L'opérateur 60 peut être considéré comme constitué de plusieurs opérateurs 61, 62, 63 et 64 associés respectivement aux groupes dont sont formés les opérandes. Nous verrons plus loin que si les opérateurs qui traitent les groupes de poids supérieur ($i = [2,3,...,K]$) présentent tous la même structure, l'opérateur 61 qui traite les groupes constitués des m bits de poids faible ($i = 1$) présente une structure simplifiée. En sortie, l'opérateur 61 fournit directement la valeur $PS_1$ du bit de parité du groupe de poids faible du résultat. En outre, l'opérateur 61 fournit la valeur de la retenue $c_{1,m+1} = c_9$ qui est la retenue $c_{2,1}$ de plus faible poids pour le groupe d'indice i=2.

Les autres circuits pour les groupes d'indice i supérieur à 1:62, 63 et 64 appartenant à l'étage 60 fournissent respectivement des variables $X_i$ et $Y_i$ définies de manière conventionnelle par les relations:

$$Y_i = G'_{i,1} \oplus G_{i,2} \oplus ... \oplus G_{i,j} \oplus ... \oplus G_{i,m-1}$$

$$X_i = P_{i,1} \oplus P_{i,2} \oplus ... \oplus P_{i,j} \oplus ... \oplus P_{i,m-1}$$

$G'_{i,1}$ étant calculé selon la relation déjà évoquée $G'_{i,1} = PA_i \oplus PB_i \oplus G_{i,1}$, de manière à calculer la parité associée à la somme S et non seulement la parité associée au mot de retenue C. Dans l'exemple arbitraire choisi de mots décomposés en quatre groupes de huit bits, la variable i prend donc les valeurs 2, 3 et 4, et la variable m vaut 8. Les circuits 62, 63 et 64 fournissent en outre en sortie la valeur de la retenue de plus faible poids du groupe de poids immédiatement supérieur. Plus précisément, l'opérateur 62 fournit la retenue $c_{2m+1} = c_{17} = c_{3,1}$, et l'opérateur 63 fournit la retenue $c_{3m+1} = c_{25} = c_{4,1}$. L'opérateur 64 fournit la retenue $c_{4m+1} = c_{33}$ qui est une variable indiquant un débordement de l'additionneur. Dans une variante, cette retenue $c_{4m+1}$ n'est pas calculée, car elle ne participe pas au calcul de la parité.

Un dernier étage constitué des opérateurs 52, 53 et 54 reçoit les variables $X_i$, $Y_i$ du groupe correspondant ainsi que le signal de retenue obtenu par l'opérateur de l'étage 60 de poids immédiatement inférieur. Plus précisément, l'opérateur 52 reçoit la retenue $c_9 = c_{2,1}$ obtenue par l'opérateur 61, l'opérateur 53 reçoit la retenue $c_{17} = c_{3,1}$ obtenue par l'opérateur 62 et l'opérateur 54 reçoit la retenue $c_{25} = c_{4,1}$ obtenue par l'opérateur 63.

D'une façon générale, en désignant par $c_{i,1}$ la retenue entrante appliquée à l'opérateur correspondant, chaque opérateur 52 à 54 délivre respectivement un signal de sortie $PS_i$ vérifiant la relation:

$$PS_i = Y_i \oplus c_{i,1} \cdot X_i^* \qquad \text{pour } (i=[2,3,...,K])$$

Il n'y a pas d'opérateur 51 dans cette réalisation, car l'opérateur 61 fournit directement en sortie la valeur $PS_1$. Les variables $PS_1$ à $PS_4$ ainsi obtenues sont donc les bits de parité associés à chacun des groupes extraits de la somme.

Il est évident que le dispositif précédent pourrait aisément être généralisé pour un nombre K quelconque de groupes et un nombre m quelconque de bits par groupe. D'autres valeurs communes dans les additionneurs sont par exemple 8 groupes de 4 bits, ou 16 groupes de 4 bits avec des additionneurs 64 bits.

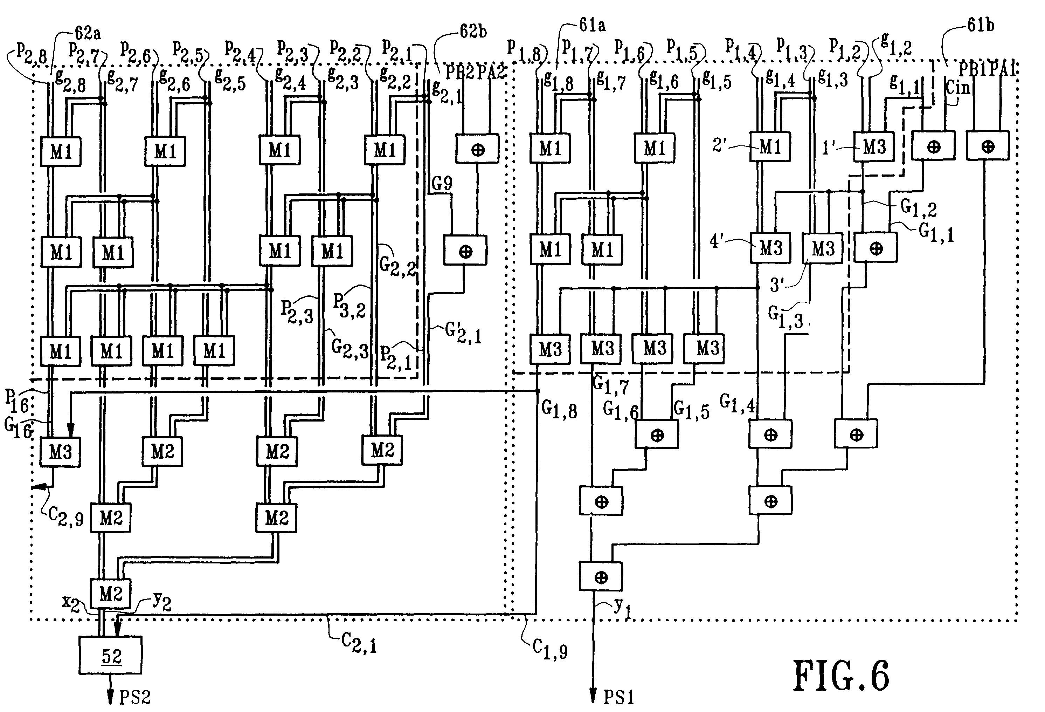

Nous allons maintenant décrire à l'aide de la figure 6 le fonctionnement du circuit de calcul de parité 60 et les simplifications que l'introduction de la retenue entrante $c_{in}$ dans le calcul du signal $g'_{1,1}$ permet de réaliser dans ce circuit.

La figure 6 représente les circuits 61 et 62 de calcul des bits de parité $PS_1$ et $PS_2$ associés aux deux groupes constitués des 2m bits consécutifs de la somme S de poids faible (groupes d'indice i = 1,2). Les circuits 63 et 64 étant identiques au circuit 62, ils ne seront pas décrits ici.

Nous allons commencer par la description du circuit 61 qui traite les groupes constitués des m bits consécutifs de la somme de poids faible (i = 1).

Le circuit 61 comprend un premier opérateur 61a recevant les variables $p_{1,2}$, $g'_{1,1}$ à $p_{1,8}$, $g_{1,8}$ calculées par le circuit 11' exposé précédemment ou par un circuit séparé mais identique. Ce circuit 11' peut en effet être commun avec l'additionneur, mais si l'on veut améliorer l'intégrité du dispositif, il est préférable d'utiliser un circuit 11' indépendant de l'additionneur car l'utilisation d'un circuit 11' commun masquerait les erreurs qui pourraient se produire dans ce circuit. La variable $p'_{1,1}$ n'est pas utilisée, et, par rapport à l'art antérieur décrit en relation avec la figure 2, la variable $g_{1,1}$ est remplacée par la variable $g'_{1,1} = a_{1,1} \cdot b_{1,1} + a_{1,1} \cdot c_{in} + b_{1,1} \cdot c_{in}$ déjà définie plus haut. Les autres variables $p_{1,2}$ à $p_{1,8}$ et $g_{1,2}$ à $g_{1,8}$ sont les mêmes que celles utilisées dans l'art antérieur.

L'opérateur 61a est constitué de modules logiques d'un premier type M1 et d'un autre type M3. Le fonctionnement de ces deux types de module est défini plus haut. L'utilisation de ces modules et leur disposition vont permettre de calculer les variables $G_{1,j}$ pour (j=[2,3,...,m]) définis par les relations de récurrence:

$$G_{1,j} = g_{1,j} + p_{1,j} \cdot G_{1,j-1} \qquad \text{avec } G_{1,1} = g'_{1,1}$$

Dans l'opérateur 61a, les variables $P_{1,j}$ ne sont pas calculées.

Toutes les valeurs $G_{1,j}$ sont modifiées, par rapport à l'art antérieur, par le remplacement de $g_{1,1}$ par la variable $g'_{1,1}$ qui tient compte de la retenue entrante $c_{in}$. Nous avons déjà vu que $g'_{1,1}$ est en fait égal à $c_{1,2}$ on a donc aussi que $G_{1,1} = c_{1,2}$. Il est possible de démontrer que les signaux consécutifs $G_{1,j}$ ont pour valeur les valeurs usuelles des retenues cumulées telles qu'ont peut les calculer à l'aide d'un additionneur à propagation de retenue, c'est-à-dire:

$$G_{1,j} = c_{1,j+1} \qquad \text{pour } (j=[1,2,...,m])$$

Nous allons maintenant indiquer la façon de construire le premier opérateur 61a en procédant par récurrence, l'indice j indiquant à la fois le poids du bit considéré et un rang correspondant de l'opérateur.

Pour j = 1, on obtient directement $G_{1,1} = g'_{1,1} = c_{1,2}$. Pour j = 2, on combine en outre $g'_{1,1}$ avec $p_{1,2}$, $g_2$ dans un premier

module M3:1' qui fournit en sortie $G_{1,2} = c_{1,3}$. Pour j = 3, un second module M3:3' combine $p_{1,3}$, $g_{1,3}$ avec $G_{1,2}$ issu du premier module M3. Ce module 3' fournit $G_{1,3} = c_{1,4}$. Pour j = 4, un premier module M1 2' combine $p_{1,3}$, $g_{1,3}$ et $p_{1,4}$, $g_{1,4}$ et la sortie de ce module est combinée dans un autre module M3 4' avec la sortie du module 1'. Ce module 4' fournit $G_{1,4}$. On obtient ce résultat grâce à l'associativité des fonctions réalisées par les modules M1 et M3.

Pour compléter la construction de l'opérateur 61a pour j supérieur à 4, il suffit de suivre la méthode suivante: le montage initial pour j compris entre 1 et 2n étant réalisé, le montage pour j compris entre $2n+1$ et $2^{n+1}$ est obtenu en ajoutant des modules M1 disposés selon ce montage initial mais décalés de 2n rangs vers les poids forts, fournissant ainsi de nouvelles sorties. On dispose ensuite 2n modules M3 supplémentaires qui combinent les sorties de plus fort poids $G_{1,2n}$ issues du montage initial et, respectivement, chacune de ces nouvelles sorties.

La construction s'arrêtera à l'ordre m (au lieu de m-1 dans la réalisation de la figure 2). Dans l'exemple considéré, nous disposons donc en sortie du premier opérateur 61a des variables $G_{1,j}$ pour (j=[1,2,...,8]). Ces variables sont respectivement égales aux retenues $c_{1,j+1}$ selon la relation évoquée.

Les sorties $G_{1,j}$ de l'opérateur 61a sont ensuite appliquées sur les entrées de l'opérateur 61b, composé de portes logiques réalisant la fonction "OU EXCLUSIF" disposées en arbre binaire. Le circuit 61 b calcule ainsi le ou-exclusif de tous les $G_{1,j}$ et de la retenue entrante $c_{1,1} = c_{in}$, c'est-à-dire la variable $Y_1$ définie comme:

$$Y_1 = c_{1,1} \oplus G_{1,1} \oplus G_{1,2} \oplus ... \oplus G_{1,j} \oplus ... \oplus G_{1,m-1}$$

Comme:

$$G_{1,j} = c_{1,j+1}$$

nous avons donc:

$$Y_1 = c_{1,1} \oplus c_{1,2} \oplus c_{1,3} \oplus ... \oplus c_{1,j} \oplus ... \oplus c_{1,m} = PC_1$$

Nous avons donc, pour ce groupe des poids faibles, que la variable $Y_1$ calculée comme précedemment mais en faisant intervenir la valeur cin dans le calcul des variables $G_{1,j}$ est égale à la parité du mot de retenue. Comme on a la relation:

$$PS_i = PA_i \oplus PB_i \oplus PC_i,$$

$PA_i$ et $PB_i$ étant les parités respectives associées aux groupes d'indice i des deux opérandes A et B, on voit que pour obtenir le bit de parité associé au groupe correspondant de la somme, il faut encore introduire les bits de parité $PA_1$ et $PB_1$ dans l'expression de $Y_1$. Dans une réalisation préférentielle telle qu'illustrée par la figure 6, l'expression $G_{1,2} \oplus G_{1,1} \oplus c_{1,1}$ est remplacée par l'expression $G_{1,2} \oplus G_{1,1} \oplus c_{1,1} \oplus PA_1 \oplus PB_1$. Nous utilisons donc pour calculer la parité associée au groupe de poids faible de la somme la valeur $Y_1$ définie par la relation:

$$Y_1 = c_{1,1} \oplus G_{1,1} \oplus G_{1,2} \oplus ... \oplus G_{1,j} \oplus ... \oplus G_{1,m-1} \oplus PA_1 \oplus PB_1 = PS_1$$

D'autres manières d'insérer la valeur $PA_1$, $PA_2$ des bits de parité des opérandes dans l'expression de $Y_1$ sont à la portée de l'homme de l'art, le tout étant matière de choix d'implémentation. De manière préférentielle, ces bits de parité seront insérés de manière à minimiser le nombre de couches logiques du circuit et de simplifier la réalisation physique.

Le circuit 61 de la figure 6 ainsi réalisé fournit directement en sortie la valeur $PS_1$ du bit de parité de la somme pour le groupe de poids faible. En outre, la sortie $G_{1,8} = c_9$ fournit la valeur du bit de retenue de plus faible poids pour le groupe d'indice i = 2, c'est-à-dire la valeur $c_{2,1}$.

L'étage 61 ainsi réalisé, dans l'exemple avec une taille de groupes m de huit bits, comporte au total 5 modules M1, 7 modules M3 et 9 portes "OU-EXCLUSIF". Pour réaliser la même fonction, dans l'art antérieur selon les figures 1 à 3, deux circuits distincts 21 et 41 étaient nécessaires. Ces deux circuits nécessitaient au total 13 modules M1, 4 modules M3, 6 modules M2 et deux portes "OU EXCLUSIF", plus un opérateur 51. Les modules M2 étant en fait constitués de deux portes "OU EXCLUSIF" et les modules M1 étant plus complexes que les modules M3, on voit que l'invention permet une sensible économie de circuits. En outre, un seul bloc 61 étant nécessaire au lieu de deux blocs parallèles

21 et 41, l'intégration avec la technologie "chemin de donnée" se trouve facilitée".

Nous allons maintenant décrire les circuits 62, 63 et 64 de calcul des bits de parité associés aux groupes de bits de la somme autre que le groupe de poids faible. Les circuits étant tous identiques, nous limiterons la description à un seul d'entre eux, par exemple le circuit 62.

Il serait naturellement possible de construire le circuit 62 sur le modèle du circuit 61, en introduisant la retenue entrante $c_{2,1}$ provenant du circuit 61 dans le calcul d'un $g'_{2,1}$ modifié, ce qui permettrait d'appliquer au circuit 62 toutes les simplifications apportées au circuit 61. Toutefois, la retenue $c_{2,1}$ n'est obtenue que tout à la fin des opérations du circuit 61. Cela signifie que le circuit 62 ne pourrait commencer à fonctionner que lorsque le circuit 61 aurait presque terminé ses opérations, ce qui serait incompatible avec l'exigence de fonctionnement rapide du dispositif.

Par conséquent, le circuit 62 sera construit de la même manière que le circuit 41 de l'art antérieur, de manière à faire intervenir cette retenue entrante $c_{2,1}$ le plus tard possible dans la suite des opérations.

Le circuit 62 se compose d'un premier opérateur 62a et d'un second opérateur 62b. Nous ne le décrirons pas en détail ici et renvoyons le lecteur à la description associée à la figure 2.

La méthode de construction itérative de l'opérateur 41a indiquée en relation avec cette figure s'applique aussi à la construction de l'opérateur 62a. Toutefois, la construction s'arrêtera à l'ordre m au lieu de s'arrêter à l'ordre m-1 comme dans l'art antérieur. Dans l'exemple considéré, nous disposerons donc en sortie de l'opérateur 62a des variables $P_{2,j}$, $G_{2,j}$ de l'ordre 1 à l'ordre 8.

Les sorties de l'opérateur 62a jusqu'à l'ordre m-1 sont ensuite appliquées aux entrées du second opérateur 62b.

L'opérateur 62b est identique à l'opérateur 41b décrit en relation avec la figure 2. Il est donc constitué de modules M2 disposés en arbre. En sortie, il fournit donc les deux variables X2 et Y2 définies par les relations:

$$X_2 = P_{2,1} \oplus P_{2,2} \oplus ... \oplus P_{2,j} \oplus ... \oplus P_{2,m-1}$$

$$Y_2 = G'_{2,1} \oplus G_{2,2} \oplus ... \oplus G_{2,j} \oplus ... \oplus G_{2,m-1}$$

Comme précédemment, la variable $G'_{2,1}$ est définie de manière à faire intervenir dans l'expression de $Y_2$ les valeurs des parités associées au groupe d'indice i = 2 des opérandes:

$$G'_{2,1} = G_{2,1} \oplus PA_2 \oplus PB_2$$

Naturellement, d'autres combinaisons des bits de parité $PA_2$ et $PB_2$ avec une ou deux variables $G_{2,j}$ ou directement avec la variable $Y_2$ sont possibles et à la portée de l'homme de l'art.

Les variables $X_2$, $Y_2$ et la retenue $c_{2,1}$ provenant de l'opérateur d'ordre immédiatement inférieur 61 sont appliquées à un opérateur 52 dont la sortie $PS_2$ est liée aux entrées par la relation:

$$PS_2 = Y_2 \oplus c_{2,1} \cdot X_2{}^\star$$

Les variables $P_{2,m}$ et $G_{2,m}$, dans l'exemple $P_{2,8}$ et $G_{2,8}$, sont appliquées avec la retenue entrante $c_{2,1}$ à un module M3. Si $c_{i,1}$ est le bit de retenue de plus faible poids dans le groupe d'indice i, on a pour j supérieur à 1 la relation:

$$c_{i,j+1} = G_{i,j} + P_{i,j} \cdot c_{i,1}$$

en posant j = m, on obtient:

$$c_{i,1} = G_{i-1,m} + P_{i-1,m} \cdot c_{i-1,1} \qquad \text{pour (i=[3,4,...K])}$$

Si i = 3 et m = 8, on a donc que la sortie de ce module M3 fournit la valeur du bit de retenue $c_{2,9}$. Cette retenue sera la retenue entrante $c_{3,1}$ du circuit 63 traitant le groupe de poids immédiatement supérieur. La présence du circuit d'anticipation des retenues 21a décrit en relation avec la figure 5 est donc superflue.

Dans cet exemple avec une taille m de huit bits, le circuit de la figure 6 utilise 12 modules M1, 6 modules M2 et un module M3. Les circuits équivalents 42 et 22 de l'art antérieur nécessitent 16 modules M1, 6 modules M2 et deux modules M3. Il y a donc une simplification importante du dispositif. En outre, la disposition topologique de ces circuits se prête mieux à une intégration avec la technologie "chemin de donnée".

Dans une réalisation préférentielle, le générateur de parité selon l'invention sera réalisé en technologie CMOS. Dans cette technologie, les fonctions réalisées par les modules M1, M2 ou M3 sont plus lentes et nécessitent plus de transistors que les fonctions complémentaires ou duales correspondantes. L'homme de l'art réalisera donc les circuits des figures 5 à 9 de préférence avec des modules réalisant les fonctions complémentaires ou duales des modules M1, M2 et M3 là où cela pourra s'avérer approprié, à condition de prévoir des inverseurs aux endroits adéquats. Toutes ces considérations dépendent de la technologie utilisée et sont matière de choix de réalisation à la portée de l'homme du métier.

**Revendications**

1. Dispositif de calcul des K bits de parité $PS_i$ associés respectivement à K groupes de m bits consécutifs extraits du résultat S de l'addition de deux nombres binaires A et B, lesdits nombres A et B comprenant chacun au moins K groupes de m bits, K étant au moins égal à 2, l'addition générant un mot de retenue C, les groupes extraits desdits nombres A,B,C et S étant formés respectivement des bits $a_{i,m}$, ..., $a_{i,j}$, ..., $a_{i,2}$, $a_{i,1}$, des bits $b_{i,m}$, ..., $b_{i,j}$, ..., $b_{i,2}$, $b_{i,1}$, des bits $c_{i,m}$, ..., $c_{i,j}$, ..., $c_{i,2}$, $c_{i,1}$ et des bits $s_{i,m}$, ..., $s_{i,j}$, ..., $s_{i,2}$, $s_{i,1}$, respectivement, l'indice i désignant un des K groupes, les groupes extraits de chaque nombre A,B,C et S constitués par les m bits de poids faibles étant désignés par un indice i = 1, et l'indice j indiquant le poids dans le groupe du bit associé, $c_{1,1}$ étant le bit de retenue entrante intervenant dans l'addition, le dispositif comprenant au moins deux étages (10', 50') de circuits, chaque étage recevant en entrée plusieurs groupes de bits extraits des opérandes ou de signaux intermédiaires calculés à partir des opérandes, un étage étant placé en aval de l'autre dans le sens de transmission des signaux dans le dispositif, chaque étage effectuant une étape distincte dans le calcul des parités PSi associées aux groupes du résultat, caractérisé en ce que le premier étage (10') placé en amont de l'autre desdit au moins deux étages utilise la valeur du bit de retenue entrante $c_{1,1}$ correspondant au groupe constitué des m bits de poids faible mais pas la valeur des autres bits de retenue entrante $c_{i,1}$ pour i=[2,3,...,K], correspondant aux autres groupes et que lesdites valeurs des autres bits de retenue interviennent seulement dans un second étage (50') placé plus en aval du premier étage (10').

2. Dispositif selon la revendication 1, caractérisé en ce que le dispositif comporte un troisième étage (60) auquel sont appliqués des signaux intermédiaires ($p_{i,j}$, $g_{i,j}$) provenant dudit premier étage et appliquant au dit second étage d'autres signaux intermédiaires ($X_i$, $Y_i$) pour le calcul des bits de parité $PS_i$ associés aux groupes du résultat, et en ce que la valeur des autres bits de retenue entrante $c_{i,1}$, pour i=[2,3,...,K] correspondant aux groupes différents du groupe composé des m bits de poids faibles est calculée dans ce troisième étage.

3. Dispositif selon la revendication 1 ou 2, caractérisé en ce que chaque groupe d'indice i extrait des nombres A et B est associé respectivement à une parité $PA_i$ et $PB_i$, et en ce que ledit dispositif comprend:

   - un dit premier étage (10') pour calculer avec i = 1 les valeurs:

$$g_{1,1} = a_{1,1} \cdot b_{1,1} + a_{1,1} \cdot c_{1,1} + b_{1,1} \cdot c_{1,1}$$

$$g_{1,j} = a_{1,j} \cdot b_{1,j} \qquad \text{pour (j=[2,3,...,m])}$$

$$p_{1,j} = a_{1,j} \oplus b_{1,j} \qquad \text{pour (j=[2,3,...,m])}$$

   - un premier opérateur (61a) appartenant au dit troisième étage pour calculer avec i = 1 pour j=[2,3,...,m] les valeurs $G_{1,j}$ vérifiant les équations logiques récurrentes suivantes:

$$G_{1,j} = g_{1,j} + p_{1,j} \cdot G_{1,j-1} \qquad \text{avec } G_{1,1} = g_{1,1},$$

   - un deuxième opérateur (G1b) appartenant au dit troisième étage pour calculer avec i = 1:

$$Y_1 = G_{1,1} \oplus G_{1,2} \oplus ... \oplus G_{1,j} \oplus ... \oplus G_{1,m-1} \oplus PA_1 \oplus PB_1$$

la valeur $Y_1$ étant égale à la parité associée au groupe de m bits de poids faible extraits du résultat.

4. Dispositif selon la revendication 3, caractérisé en ce que:

- ledit premier étage (10') calcule en outre pour tout couple (i,j) avec i=[2,3,...,K] et j=[1,2,...,m] les valeurs:

$$p_{i,j} = a_{i,j} \oplus b_{i,j}$$

$$g_{i,j} = a_{i,j} \cdot b_{i,j}$$

- ledit premier opérateur (60a) appartenant au dit troisième étage calcule en outre pour tout couple (i,j) avec i= [2,3,...,K] et j=[2,3,...,m] les valeurs $G_{i,j}$ et $P_{i,j}$ vérifiant les équations logiques récurrentes suivantes:

$$G_{i,j} = g_{i,j} + p_{i,j} \cdot G_{i,j-1} \qquad \text{avec } G_{i,1} = g_{i,1},$$

$$P_{i,j} = p_{i,j} \cdot P_{i,j-1} \qquad \text{avec } P_{i,1} = p_{i,1}$$

- ledit deuxième opérateur (60b) appartenant au dit troisième étage calcule en outre pour i=[2,3,...,K]:

$$Y_i = G_{i,1} \oplus G_{i,2} \oplus ... \oplus G_{i,j} \oplus ... \oplus G_{i,m-1} \oplus PA_i \oplus PB_i$$

$$X_i = P_{i,1} \oplus P_{i,2} \oplus ... \oplus P_{i,j} \oplus ... \oplus P_{i,m-1}$$

la parité associée aux groupes de m bits extraits du résultat autres que le groupe formé des m bits de poids faible étant alors calculée par un troisième opérateur (50) appartenant au dit second étage à l'aide de la relation:

$$PS_i = Y_i \oplus c_{i,1} \cdot X_i^* \qquad \text{pour i compris entre 2 et K}$$

où $c_{i,1}$ est la retenue de plus faible poids du groupe d'indice i et où $X_i^*$ est le complément de $X_i$.

5. Dispositif selon la revendication 4, caractérisé en ce que la retenue de plus faible poids $c_{i,1}$ pour i=[2,3,...,K] utilisée par ledit troisième opérateur pour les groupes autres que le groupe de poids faible est déterminée dans ledit premier opérateur:

- pour i = 2, comme étant égale à la valeur $G_{1,m}$ calculée à partir du groupe constitué des m bits de poids faible
- pour i=[3,4,...,K], en appliquant aux entrées d'un module d'un troisième type (M3) les sorties $P_{i-1,m}$ et $G_{i-1,m}$ provenant du premier opérateur ainsi que la retenue entrante $c_{i-1,1}$ du groupe de poids immédiatement inférieur, la sortie du module M3 fournissant la valeur:

$$c_{i,1} = G_{i-1,m} + P_{i-1,m} \cdot c_{i-1,1}$$

6. Dispositif selon l'une des revendications précédentes, caractérisé en ce que la partie du premier opérateur chargée du traitement des groupes constitués des m bits de poids faible utilise des modules d'un premier type (M1) et des modules d'un troisième type (M3), les modules d'un premier type opérant sur quatre entrées Px, Gx, Py, Gy et fournissant deux sorties Pz, Gz liées aux entrées par les relations suivantes:

$$Pz = Py \cdot Px$$

$$Gz = Gy + Py \cdot Gx,$$

les modules d'un troisième type opérant sur trois entrées Px, Gx et cy et fournissant une sortie cz vérifiant la relation:

$$cz = Gx + Px \cdot cy$$

lesdits modules étant montés conformément à la méthode récurrente suivante:

a) Pour j = 1, on obtient directement $G_{1,1} = g_{1,1}$

b) Pour j = 2, un premier module M3 (1') opère sur $p_{1,2}$, $g_{1,2}$ et $g_{1,1}$ et fournit $G_{1,2}$

c) Pour j compris entre 3 et 4, un second module M1 (2') opère sur $p_{1,3}$, $g_{1,3}$ et $p_{1,4}$, $g_{1,4}$, un troisième module M3 (3') opère sur $G_{1,2}$ et $p_{1,3}$, $g_{1,3}$ et fournit $G_{1,3}$, un quatrième module M3 (4') opère sur $G_{1,2}$ et les sorties du deuxième module (2') et fournit $G_{1,4}$

d) le montage initial pour j compris entre 1 et $2^n$ étant réalisé, le montage pour j compris entre $2^n+1$ et $2^n+1$ est obtenu en ajoutant des modules M1 disposés selon ledit montage initial mais décalés de $2^n$ rangs vers les poids forts, fournissant ainsi de nouvelles sorties, $2^n$ sorties du troisième type (M3) supplémentaires étant disposés pour opérer sur les sorties du plus fort poids $G_{1,2^n}$ issues dudit montage initial et respectivement chacune desdites nouvelles sorties.

7. Dispositif selon la revendication précédente, caractérisé en ce que la partie dudit deuxième opérateur (61b) chargée du traitement des groupes constitués des m bits de poids faible est constitué de portes logiques de type "OU EXCLUSIF" disposés en arbre qui reçoit en entrée les sorties $G_{1,j}$ jusqu'à $G_{1,m-1}$ du premier opérateur, les parités PA1 et PB1 associées aux groupes des opérandes constitués des m bits de poids faible ainsi que la retenue entrante $c_{1,1}$, ces signaux étant pris deux à deux autant que possible, et les portes logiques étant disposées de manière à calculer

$$Y_1 = PA1 \oplus PB1 \oplus c_{1,1} \oplus G_{1,1} \oplus G_{1,2} \oplus ... \oplus G_{1,j} \oplus ... \oplus G_{1,m-1}$$

8. Dispositif selon l'une des revendications précédentes, caractérisé en ce que ledit premier étage (10') est commun avec l'additionneur associé audit dispositif.

9. Dispositif selon l'une des revendications 1 à 7, caractérisé en ce que ledit premier étage (10') est distinct de l'additionneur associé audit dispositif.

10. Dispositif selon l'une des revendications précédentes caractérisé en ce que la réalisation est effectuée à l'aide d'opérateurs logiques CMOS de type "NON-ET", "NON-OU", "NON-OU-EXCLUSIF".

## Patentansprüche

1. Vorrichtung zum Berechnen von K Paritätsbits $PS_i$, wovon jedes einer von K Gruppen von m aufeinanderfolgenden, extrahierten Bits des Ergebnisses S der Addition zweier Binärzahlen A und B zugeordnet ist, wobei die Zahlen A und B jeweils wenigstens K Gruppen von m Bits enthalten, wobei K wenigstens gleich 2 ist, wobei die Addition ein Übertragwort C erzeugt, wobei die extrahierten Gruppen der Zahlen A, B, C und S aus Bits $a_{i,m}, ..., a_{i,j}..., a_{i,2}, a_{i,1}$, aus Bits $b_{i,m}, ..., b_{i,j}...b_{i,2}, b_{i,1}$, aus Bits $c_{i,m}, ...c_{i,j}..., c_{i,2}, c_{i,1}$ bzw. aus Bits $s_{i,m}, ..., s_{i,j}..., s_{i,2}, s_{i,1}$ gebildet sind, wobei der Index i eine der K Gruppen bezeichnet, wobei die extrahierten Gruppen jeder Zahl A, B, C und S, die aus den m Bits mit niedriger Wertigkeit gebildet sind, durch einen Index i = 1 bezeichnet sind, wobei der Index j die Wertigkeit in der Gruppe des zugeordneten Bits bezeichnet, $c_{1,1}$ das ankommende Übertragbit ist, das in die Addition eingeht, wobei die Vorrichtung wenigstens zwei Schaltungsstufen (10', 50') enthält, wovon jede an ihrem Eingang mehrere Gruppen von extrahierten Bits von Operanden oder von anhand dieser Operanden berechneten Zwischensignalen empfängt, wobei eine Stufe in Richtung der Übertragung der Signale in der Vorrichtung hinter der anderen angeordnet ist, wobei jede Stufe in der Berechnung der Paritäten PSi, die den Gruppen des Ergebnisses zugeordnet sind, einen unterschiedlichen Schritt ausführt, dadurch gekennzeichnet, daß die erste Stufe 10', die vor der anderen der wenigstens zwei Stufen angeordnet ist, den Wert des ankommenden Übertragbits $c_{1,1}$, das der Gruppe entspricht, die aus m Bits mit niedriger Wertigkeit gebildet ist, jedoch nicht den Wert der anderen ankommenden Übertragbits $c_{i,1}$ für i = [2, 3,..., K], die den anderen Gruppen entsprechen, verwendet, und daß die Werte der anderen Übertragbits nur in einer zweiten Stufe (50') wirken, die sich weiter hinter der ersten Stufe (10') befindet.

2. Vorrichtung nach Anspruch 1, dadurch gekennzeichnet, daß die Vorrichtung eine dritte Stufe (60) enthält, in die Zwischensignale $(p_{i,j}, g_{i,j})$ eingegeben werden, die von der ersten Stufe stammen, und an die zweite Stufe andere Zwischensignale $(X_i, Y_i)$ für die Berechnung der Paritätsbits $PS_i$, die den Gruppen des Ergebnisses zugeordnet sind, anlegt, und daß der Wert der anderen ankommenden Übertragbits $c_{i,1}$ für i = [2, 3,..., K], die den Gruppen entsprechen, die von der aus den m Bits mit niedriger Wertigkeit aufgebauten Gruppe verschieden sind, in dieser dritten Stufe berechnet wird.

3. Vorrichtung nach Anspruch 1 oder 2, dadurch gekennzeichnet, daß jeder Gruppe mit Index i, die den Zahlen A und B entnommen ist, eine Parität $PA_i$ bzw. $PB_i$ zugeordnet ist und daß die Vorrichtung enthält:

- eine erste Stufe (10'), um mit i = 1 die folgenden Werte zu berechnen:

$$g_{1,1} = a_{1,1} \bullet b_{1,1} + a_{1,1} \bullet c_{1,1} + b_{1,1} \bullet c_{1,1}$$

$$g_{1,j} = a_{1,j} \bullet b_{1,j} \qquad \text{für (j=[2,3,...m]}$$

$$p_{1,j} = a_{1,j} \oplus b_{1,j} \qquad \text{für (j=[2,3,...m]}$$

- einen ersten Operator (61a), der zur dritten Stufe gehört, um mit i = 1 für j = [2, 3,..., m] die Werte $G_{1,j}$ zu berechnen, die die folgenden rekursiven logischen Gleichungen erfüllen

$$G_{1,j} = g_{1,j} + p_{1,j} \bullet G_{1,j-1} \qquad \text{mit } G_{1,1} = g_{1,1}$$

- einen zweiten Operator (G1b), der zur dritten Stufe gehört, um mit i = 1 zu berechnen:

$$Y_1 = G_{1,1} \oplus G_{1,2} \oplus ... \oplus G_{1,j} \oplus ... \oplus G_{1,m-1} \oplus PA_1 \oplus PB_1$$

wobei der Wert $Y_1$ gleich der Parität ist, die der Gruppe von m extrahierten Bits mit niedriger Wertigkeit des Ergebnisses zugeordnet ist.

4. Vorrichtung nach Anspruch 3, dadurch gekennzeichnet, daß:

- die erste Stufe (10') außerdem für jedes Paar (i,j) mit i = [2, 3,..., K] und j =[1, 2,..., m] die folgenden Werte berechnet:

$$p_{i,j} = a_{i,j} \oplus b_{i,j}$$

$$g_{i,j} = a_{i,j} \bullet b_{i,j}$$

- der erste Operator (60a), der zur dritten Stufe gehört, außerdem für jedes Paar (i,j) mit i = [2, 3,..., K] und j = [2, 3,..., m] die Werte $G_{i,j}$ und $P_{i,j}$ berechnet, die die folgenden rekursiven logischen Gleichungen erfüllen:

$$G_{i,j} = g_{i,j} + p_{i,j} \bullet G_{i,j-1} \qquad \text{mit } G_{i,1} = g_{i,1}$$

$$P_{i,j} = p_{i,j} \bullet P_{i,j-1} \qquad \text{mit } P_{i,1} = p_{i,1}$$

- der zweite Operator (60b), der zur dritten Stufe gehört, außerdem für i = [2, 3,..., K] berechnet:

$$Y_i = G_{i,1} \oplus G_{i,2} \oplus ... \oplus G_{i,j} \oplus ... \oplus G_{i,m-1} \oplus PA_i \oplus PB_i$$

$$X_i = P_{i,1} \oplus P_{i,2} \oplus ... \oplus P_{i,j} \oplus ... \oplus P_{i,m-1}$$

wobei die Parität, die den Gruppen von m extrahierten Bits des Ergebnisses zugeordnet ist, die von der Gruppe verschieden sind, die aus den m Bits mit niedriger Wertigkeit gebildet ist, dann durch einen dritten Operator (50), der zur zweiten Stufe gehört, mit Hilfe der folgenden Beziehung berechnet wird:

$$PS_i = Y_i \oplus C_{i,1} \bullet X_i^*$$

mit i von 2 bis K wobei $c_{i,1}$ der Übertrag mit niedriger Wertigkeit der Gruppe mit Index i ist und wobei $X_i^*$ das Komplement von $X_i$ ist.

5. Vorrichtung nach Anspruch 4, dadurch gekennzeichnet, daß der Übertrag mit niedriger Wertigkeit $c_{i,1}$ für i = [2, 3,..., K], der vom dritten Operator für die von der Gruppe mit niedriger Wertigkeit verschiedenen Gruppen verwendet wird, im ersten Operator bestimmt wird:

- für i = 2 als gleich mit dem Wert $G_{1,m}$, der anhand der Gruppe berechnet wird, die aus den m Bits mit niedriger Wertigkeit gebildet ist,
- für i = [3, 4,..., K], indem an die Eingänge eines Moduls eines dritten Typs (M3) die Ausgangssignale $P_{i-1,m}$ und $G_{i-1,m}$, die vom ersten Operator stammen, sowie der ankommende Übertrag $c_{i-1,1}$ der Gruppe mit direkt darunterliegender Wertigkeit angelegt werden, wobei der Ausgang des Moduls M3 den folgenden Wert liefert:

$$c_{i,1} = G_{i-1,m} + P_{i-1,m} \bullet c_{i-1,1} \cdot$$

6. Vorrichtung nach einem der vorangegangenen Ansprüche, dadurch gekennzeichnet, daß der Teil des ersten Operators, der die Verarbeitung der Gruppen ausführen soll, die aus den m Bits mit niedriger Wertigkeit gebildet sind, Module eines ersten Typs (M1) und Module eines dritten Typs (M3) verwendet, wobei die Module eines ersten Typs mit vier Eingängen Px, Gx, Py, Gy arbeiten und zwei Ausgänge Pz, Gz liefern, die mit den Eingängen über die folgende Beziehungen verbunden sind:

$$Pz = Py \bullet Px$$

$$Gz = Gy + Py \bullet Gx$$

wobei die Module eines dritten Typs mit drei Eingängen Px, Gx und cy arbeiten und einen Ausgang cz liefern, der die folgende Beziehung erfüllt:

$$cz = Gx + Px \bullet cy$$

wobei die Module in Übereinstimmung mit dem folgenden Rekursionsverfahren angeordnet sind:

a) für j = 1 wird direkt $G_{1,1} = g_{1,1}$ erhalten
b) für j = 2 arbeitet ein erstes Modul M3 (1') mit $p_{1,2}$, $g_{1,2}$ und $g_{1,1}$ und liefert $G_{1,2}$,
c) für j von 3 bis 4 arbeitet ein zweites Modul M1 (2') mit $p_{1,3}$, $g_{1,3}$ und $p_{1,4}$, $g_{1,4}$, arbeitet ein drittes Modul M3 (3') mit $G_{1,2}$ und $p_{1,3}$, $g_{1,3}$ und liefert $G_{1,3}$, und arbeitet ein viertes Modul M3 (4') mit $G_{1,2}$ und den Ausgängen des zweiten Moduls (2') und liefert $G_{1,4}$,

d) da der anfängliche Aufbau für j von 1 bis $2^n$ verwirklicht ist, wird der Aufbau für j von $2^n + 1$ bis $2^n + 1$ erhalten, indem Module M1 hinzugefügt werden, die entsprechend dem anfänglichen Aufbau angeordnet sind, jedoch um $2^n$ Ränge zu den höheren Wertigkeiten verschoben sind und somit neue Ausgänge liefern, wobei $2^n$ zusätzliche Ausgänge des dritten Typs (M3) vorgesehen sind, um mit den Ausgängen mit höherer Wertigkeit $G_{1,2}n$ zu arbeiten, die von dem anfänglichen Aufbau und von den jeweiligen neuen Ausgängen extrahiert werden.

7. Vorrichtung nah dem vorangehenden Anspruch, dadurch gekennzeichnet, daß der Teil des zweiten Operators (61b), der die Verarbeitung der aus den m Bits mit niedriger Wertigkeit gebildeten Gruppen ausführen soll, aus Logikgattern des Typs "Exklusiv-ODER" gebildet sind, die in Form eines Baums angeordnet sind, der an seinem Eingang die Ausgänge $G_{1,j}$ bis $G_{1,m-1}$ des ersten Operators, die Paritäten PA1 und PB1, die den Gruppen der Operanden zugeordnet sind, die aus den m Bits mit niedriger Wertigkeit gebildet sind, sowie den ankommenden Übertrag $c_{1,1}$ empfängt, wobei diese Signale soweit wie möglich paarweise abgegriffen werden und wobei die Logikgatter in der Weise angeordnet sind, daß sie berechnen:

$$Y_1 = PA1 \oplus PB1 \oplus c_{1,1} \oplus G_{1,1} \oplus G_{1,2} \oplus ... \oplus G_{1,j} \oplus ... \oplus G_{1,m-1}$$

8. Vorrichtung nach einem der vorangehenden Ansprüche, dadurch gekennzeichnet, daß die erste Stufe (10') dem Addierer, der der Vorrichtung zugeordnet ist, gemeinsam ist.

9. Vorrichtung nach irgendeinem der Ansprüche 1 bis 7, dadurch gekennzeichnet, daß die erste Stufe (10') von dem Addierer, der der Vorrichtung zugeordnet ist, verschieden ist.

10. Vorrichtung nach irgendeinem vorangehenden Anspruch, dadurch gekennzeichnet, daß die Ausführung mit Hilfe von CMOS-Logikoperatoren des Typs "Nicht-UND", "Nicht-ODER" und "Nicht-Exklusiv-ODER" erfolgt.

## Claims

1. Device for calculating the K parity bits PS, associated respectively with K groups of m consecutive bits extracted from the result S of adding two binary numbers A and B, said numbers A and B each comprising at least K groups of m bits, K being at least equal to 2, the addition generating a carry word C, the groups extracted from said numbers A, B, C and S being formed respectively of the bits $a_{i,m}$ ..., $a_{i,j}$, ..., $a_{i,2}$, $a_{i,1}$, the bits $b_{i,m}$, ..., $b_{i,j}$, ..., $b_{i,2}$, $b_{i,1}$, the bits $c_{i,m}$, ..., $c_{i,j}$, ..., $c_{i,2}$, $c_{i,1}$, and the bits $s_{i,m}$, ..., $s_{i,j}$, ..., $s_{i,2}$, $s_{i,1}$, respectively, the index i denoting one of the K groups, the groups extracted from each number A, B, C and S constituted by the m least significant bits being denoted by an index $i = 1$, and the index j indicating the significance in the group of the associated bit, $c_{1,1}$ being the ingoing carry bit involved in the addition, the device comprising at least two stages (10', 50') of circuits, each stage receiving as an input several groups of extracted bits of the operands or intermediate signals calculated on the basis of the operands, one stage being placed downstream of the other in the direction in which signals are transmitted in the device, each stage performing a distinct step in the calculation of the parities PSi associated with the groups of the result, characterised in that the first stage (10') placed upstream of the other one of said at least two stages uses the value of the ingoing carry bit $c_{1,1}$ corresponding to the group constituted by the m least significant bits but not the value of the other ingoing carry bits $c_{i,1}$, for $i = [2, 3, ..., K]$, corresponding to the other groups and that said values of the other carry bits are involved only at a second stage (50') placed further downstream of the first stage (10').

2. Device according to Claim 1, characterised in that the device comprises a third stage (60) to which are applied intermediate signals $(p_{i,j}, g_{i,j})$ coming from said first stage and applying to said second stage other intermediate signals $(X_i, Y_i)$ for calculating the parity bits $PS_i$ associated with the groups of the result, and in that the value of the other ingoing carry bits $c_{i,1}$, for $i = [2, 3, .., K]$, corresponding to the various groups of the group composed of the m least significant bits is calculated at this third stage.

3. Device according to Claim 1 or 2, characterised in that each group of index i extracted from the numbers A and B is associated respectively with a parity $PA_i$ and $PB_i$, and in that said device comprises:

   - what is known as a first stage (10'), for calculating with $i = 1$ the values:

$$g_{1,1} = a_{1,1} \cdot b_{1,1} + a_{1,1} \cdot c_{1,1} + b_{1,1} \cdot c_{1,1}$$

$$g_{1,j} = a_{1,j} \cdot b_{1,j} \qquad \text{for } (j = [2, 3, ..., m])$$

$$P_{1,j} = a_{1,j} \oplus b_{1,j} \qquad \text{for } (j = [2, 3, ..., m])$$

- a first operator (61a) belonging to said third stage for calculating with i = 1 for j = [2, 3, ..., m] the values $G_{1,j}$ verifying the following recurrent logical equations:

$$G_{1,j} = g_{1,j} + p_{1,j} \cdot G_{1,j.1} \text{ with } G_{1,1} = 9_{1,1},$$

- a second operator (G1b) belonging to said third stage for calculating with i = 1:

$$Y_1 = G_{1,1} \oplus G_{1,2} \oplus ... \oplus G_{1,j} \oplus ... G_{1,m-1} \oplus PA_1 \oplus PB_1$$

the value Y, being equal to the parity associated with the group of m least significant bits extracted from the result.

4. Device according to Claim 3, characterised in that:

- said first stage (10') also calculates for any pair (i,j) with i = [2, 3, ..., K] and j = [1, 2, ..., m] the values:

$$p_{1,j} = a_{1,j} \oplus b_{1,j}$$

$$g_{1,j} = a_{1,j} \cdot b_{1,j}$$

- said first operator (60a) belonging to said third stage also calculates for any pair (i,j) with i = [2, 3, ..., K] and j = [2, 3, ..., m] the values $G_{i,j}$, and $P_{i,j}$ verifying the following recurrent logical equations:

$$G_{i,j} \ g_{i,j} + p_{i,j} \cdot G_{i,j.1}, \qquad \text{with } G_{i,1} = g_{i,1},$$

$$P_{i,j} = p_{i,j} \cdot P_{i,j.1} \qquad \text{with } Pi,1 = pi.1,$$

- said second operator (60b) belonging to said third stage also calculates for i = [2, 3, ..., K].

$$Y_i = G_{i,1} \oplus G_{i,2} \oplus ... \oplus G_{i,j} \oplus ... \oplus G_{i,m-1} \oplus PA_i \oplus PB_i$$

$$X_i = P_{i,1} \oplus P_{i,2} \oplus ... \oplus P_{i,j} ... \oplus P_{i,m-1}$$

the parity associated with the groups of m bits extracted from the result other than the group formed by the m least significant bits then being calculated by a third operator (50) belonging to said second stage with the aid of the relation:

$$PS_i = Y_i \oplus c_{i,j} \cdot X_i^*$$

for i comprised between 2 and K where $c_{i,1}$ is the least significant carry digit of the group of index i and where

$X_i{}^*$ is the complement of $X_i$.

5. Device according to Claim 4, characterised in that the least significant carry digit $c_{i,1}$ for i = [2, 3, ..., K] used by said third operator for groups other than the least significant group is determined in said first operator:

- for i = 2, as being equal to the value $G_{1,m}$ calculated on the basis of the group constituted by the m least significant bits

- for i = [3, 4, ..., K], by applying to the inputs of a third type of module (M3) the outputs $P_{i-1,m}$ and $G_{i-1,m}$ coming from the first operator and the ingoing carry digit $c_{i-1,1}$ of the immediately less significant group, the output of the module M3 providing the value:

$$c_{i,1} = G_{i-1,m} + P_{i-1,m} \cdot c_{i-1,1}$$

6. Device according to one of the preceding claims, characterised in that the part of the first operator that is responsible for processing groups constituted by the m least significant bits uses modules of a first type (M1) and modules of a third type (M3), the modules of a first type operating on four inputs Px, Gx, Py, Gy and supplying two outputs Pz, Gz linked to the inputs by the following relations:

$$Pz = Py.Px$$

$$Gz = Gy + Py.Gx$$

the modules of a third type operating on three inputs Px, Gx and cy and supplying an output cz verifying the relation:

$$cz = Gx + Px.cy$$

said modules being configured in accordance with the following recurrent method:

a) For j = 1, one obtains directly $G_{1,1} = g_{1,1}$

b) For j = 2, a first module M3 (1') operates on $p_{1,2}$, $g_{1,2}$ and $g_{1,1}$, and supplies $G_{1,2}$

c) For j comprised between 3 and 4, a second module M1 (2') operates on $p_{1,3}$, $g_{1,3}$ and $p_{1,4}$, $g_{1,4}$, a third module M3 (3') operates on $G_{1,2}$ and $p_{1,3}$, $g_{1,3}$ and supplies $G_{1,3}$, a fourth module M3 (4') operates on $G_{1,2}$ and the outputs of the second module (2') and supplies $G_{1,4}$

d) the initial configuration for j comprised between 1 and $2^n$ being done, the configuration for j comprised between $2^n+1$ and $2^n+1$ is obtained by adding modules MI arranged according to their initial configuration but offset by $2^n$ rows in the direction of the most significant bits, thus supplying new outputs, $2^n$ additional outputs of the third type (M3) being arranged so as to operate on the outputs of the most significant bits $G_{1,2^n}$ coming from said initial configuration and, respectively, each of said new outputs.

7. Device according to the preceding claim, characterised in that the part of said second operator (61b) responsible for processing the groups constituted by the m least significant bits is constituted by logic gates of the "EXCLUSIVE OR" type arranged in a tree structure, which receives as its input the outputs $G_{1,j}$ to G1,m-1 of the first operator, the parities PA1 and PB1 associated with the groups of operands constituted by the m least significant bits and the ingoing carry digit $c_{1,1}$, these signals being taken two by two as far as possible, and the logic gates being arranged so as to calculate

$$Y1 = PA1 \oplus PB1 \oplus c_{1,1} \oplus G_{1,1} \oplus G_{1,2} \oplus ... G_{1,j} \oplus ... \oplus G_{1,m-1}$$

8. Device according to one of the preceding claims, characterised in that said first stage (10') is common with the adder associated with said device.

9. Device according to one of Claims 1 to 7, characterised in that said first stage (10') is distinct from the adder associated with said device.

10. Device according to one of the preceding claims characterised in that production takes place with the aid of CMOS logic operators of the "NAND", "NOR", "EXCLUSIVE NOR" type.

FIG.1

EP 0 655 685 B1

FIG.2

EP 0 655 685 B1

FIG.3

EP 0 655 685 B1

FIG.4

FIG.5

FIG.6

EP 0 655 685 B1

FIG.7

$P_x$

$P_y$

$G_x$

$G_y$

$P_Z$

$G_Z$

M1

FIG.8

$X_x$

$X_y$

$Y_x$

$Y_y$

$X_Z$

$Y_Z$

M2

FIG.9

$P_x$

$C_y$

$G_x$

$C_Z$

M3